# EUROPEAN PATENT APPLICATION

(11) **EP 4 478 405 A2**
(43) Date of publication of application: **18.12.2024**
(21) Application number: 24158433.3
(22) Date of filing: 19.02.2024
(51) Int. Cl.: H01L 21/8234, H01L 27/088, H01L 29/06, H01L 29/10, H01L 29/66, H01L 29/775, H01L 29/786

(54) **SEMICONDUCTOR DEVICE AND METHOD OF FABRICATING THE SAME**

(30) Priority: 16.06.2023 KR 20230077325
(71) Applicant: Samsung Electronics Co., Ltd., Suwon-si, Gyeonggi-do 16677 (KR)
(72) Inventor: PARK, Beom Jin, 16677 Suwon-si (KR); KANG, Myung Gil, 16677 Suwon-si (KR); KIM, Dong Won, 16677 Suwon-si (KR); NOH, Chang Woo, 16677 Suwon-si (KR); JEON, Yu Jin, 16677 Suwon-si (KR)
(74) Representative: Marks & Clerk LLP

(57) **Abstract**

The present disclosure relates to semiconductor devices. An example semiconductor device includes a substrate (100) including first (I) and second (II) regions, a first bridge pattern (111) extending in a first direction on the first region, a first gate structure (GS1) extending in a second direction intersecting the first direction, first epitaxial patterns (160) connected to the first bridge pattern on side surfaces of the first gate structure, first inner spacers (145) interposed between the substrate and the first bridge pattern and between the first gate structure and the first epitaxial patterns, a second bridge pattern (211) extending in the first direction on the second region, a second gate structure (GS2) extending in the second direction, second epitaxial patterns (260) connected to the second bridge pattern on side surfaces of the second gate structure, and second inner spacers (245) interposed between the substrate and the second bridge pattern and between the second gate structure and the second epitaxial patterns.

## Description

### TECHNICAL FIELD

The present disclosure relates to semiconductors, and more particularly, to semiconductor devices and methods of fabricating a semiconductor device.

### BACKGROUND

As a scaling technique for increasing the density of integrated circuit devices, the concept of a multi-gate transistor has been proposed in which a silicon body in the form of a fin or nanowire is formed on a substrate and a gate is formed on the surface of the silicon body.

The multi-gate transistor takes advantage of its three-dimensional (3D) channel, allowing for easy scaling both up and down. Additionally, the multi-gate transistor offers improved control over current without the need to increase the gate length. Furthermore, the multi-gate transistor effectively mitigates the short channel effect (SCE), which is the phenomenon where the electric potential of a channel region is affected by the drain voltage.

### SUMMARY

The present disclosure relates to semiconductor devices, including a semiconductor device with improved performance, as well as methods of fabricating a semiconductor device with improved performance.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

In some implementations, a semiconductor device comprises a substrate including a first region and a second region, a first bridge pattern on the first region, the first bridge pattern extending in a first direction being spaced apart from the substrate, and having a first width, a first gate structure extending in a second direction, which intersects the first direction, the first gate structure being penetrated by the first bridge pattern, first epitaxial patterns connected to the first bridge pattern, on side surfaces of the first gate structure, first inner spacers interposed between the substrate and the first bridge pattern and between the first gate structure and the first epitaxial patterns, a second bridge pattern extending in the first direction on the second region being spaced apart from the substrate, the second bridge pattern having a second width, which is greater than the first width, a second gate structure extending in the second direction, the second gate structure being penetrated by the second bridge pattern, second epitaxial patterns connected to the second bridge pattern, on side surfaces of the second gate structure, and second inner spacers interposed between the substrate and the second bridge pattern and between the second gate structure and the second epitaxial patterns, wherein a first thickness of the first inner spacers in the first direction is greater than a second thickness of the second inner spacers in the first direction.

In some implementations, a semiconductor device comprises a substrate including a first region and a second region, a first bridge pattern and a second bridge pattern sequentially stacked on the first region, the first bridge pattern and the second bridge pattern extending in a first direction being spaced apart from the substrate, a first gate structure extending in a second direction, which intersects the first direction, the first gate structure being penetrated by the first pattern and the second bridge pattern, first inner spacers on side surfaces of the first gate structure between the first bridge pattern and the second bridge pattern, first epitaxial patterns connected to the first bridge pattern and the second bridge pattern, on outer side surfaces of the first inner spacers, a third bridge pattern and a fourth bridge pattern sequentially stacked on the second region, the third and fourth bridge patterns extending in the first direction, a second gate structure extending in the second direction and being penetrated by the third bridge pattern and the fourth bridge pattern, second inner spacers disposed on side surfaces of the second gate structure between the third bridge pattern and the fourth bridge pattern, and second epitaxial patterns connected to the third bridge pattern and the fourth bridge pattern, on outer side surfaces of the second inner spacers, wherein a first width of the first bridge pattern and the second bridge pattern in the second direction is less than a second width of the third and fourth bridge patterns in the second direction, and a first thickness of the first inner spacers in the first direction is greater than a second thickness of the second inner spacers in the first direction.

In some implementations, a semiconductor device comprises a substrate including a first region and a second region, which are arranged along a first direction, and a third region, which is between the first region and the second region, a channel structure including a first bridge pattern, which extends in the first direction on the first region and has a first width, a second bridge pattern, which extends in the first direction on the second region and has a second width greater than the first width, and a transition pattern, which connects the first bridge pattern and the second bridge pattern on the third region, a first gate structure extending in a second direction, which intersects the first direction, on the first region, the first gate structure being penetrated by the first bridge pattern, first epitaxial patterns connected to the first bridge pattern, on side surfaces of the first gate structure, first inner spacers interposed between the substrate and the first bridge pattern and between the first gate structure and the first epitaxial patterns, a second gate structure extending in the second direction on the second region, the second gate structure being penetrated by the second bridge pattern, second epitaxial patterns connected to the second bridge pattern, on side surfaces of the second gate structure, and second inner spacers interposed between the substrate and the second bridge pattern and between the second gate structure and the second epitaxial patterns, wherein a first thickness of the first inner spacers in the first direction is different from a second thickness of the second inner spacers in the first direction.

At least some of the above and other features of the disclosure are set out in the claims.

It should be noted that the effects of the present disclosure are not limited to those described above, and other effects of the present disclosure will be apparent from the following description.

### BRIEF DESCRIPTION OF THE DRAWINGS

The above and other aspects and features of the present disclosure will become more apparent by describing in detail example implementations thereof with reference to the attached drawings.
FIG. 1 is a layout view of an example of a semiconductor device.
FIG. 2 illustrates example cross-sectional views taken along lines A1-A1 and A2-A2 of FIG. 1.
FIG. 3 illustrates example enlarged cross-sectional views of regions R1 and R2 of FIG. 2.
FIG. 4 illustrates example cross-sectional views taken along lines B1-B1 and B2-B2 of FIG. 1.
FIG. 5 illustrates example cross-sectional views taken along lines C1-C1 and C2-C2 of FIG. 1.
FIGS. 6 through 8 are enlarged cross-sectional views of an example of a semiconductor device.
FIG. 9 illustrates cross-sectional views of an example of a semiconductor device.
FIG. 10 is a layout view of another example of a semiconductor device.
FIG. 11 illustrates example cross-sectional views taken along lines A1-A1 and A2-A2 of FIG. 10.
FIG. 12 illustrates example enlarged cross-sectional views of regions R3 and R4 of FIG. 11.
FIG. 13 illustrates enlarged cross-sectional views of another example of a semiconductor device.
FIG. 14 illustrates cross-sectional views of another example of a semiconductor device.
FIG. 15 is a layout view of another example of a semiconductor device.
FIG. 16 is an example cross-sectional view taken along line A3-A3 of FIG. 15.
FIGS. 17A and 17B are example cross-sectional views of semiconductor devices.
FIG. 18 is a layout view of another example of a semiconductor device.
FIG. 19 is an example cross-sectional view taken along line A3-A3 of FIG. 18.
FIG. 20 is a cross-sectional view of another example of a semiconductor device.
FIGS. 21 and 22 are example layout views of semiconductor devices.
FIGS. 23 through 31 are layout views or cross-sectional views illustrating intermediate steps of an example of a method of fabricating a semiconductor device.
FIGS. 32 through 34 are cross-sectional views illustrating intermediate steps of an example of a method of fabricating a semiconductor device.
FIGS. 35 and 36 are cross-sectional views illustrating intermediate steps of another example of a method of fabricating a semiconductor device.
FIGS. 37 and 38 are cross-sectional views illustrating intermediate steps of another example of a method of fabricating a semiconductor device.

### DETAILED DESCRIPTION

It should be understood that the terms "first," "second," "third," etc., used herein to describe various elements, components, regions, layers, and/or sections are employed for the purpose of distinguishing one element, component, region, layer, or section from another. Therefore, a first element, component, region, layer, or section described below could also be referred to as a second element, component, region, layer, or section, without deviating from the essence and scope of the present disclosure.

Also, in this specification, the term "same" or "identical" encompasses not only complete identity, but also minor variances that may arise due to process margins or other factors.

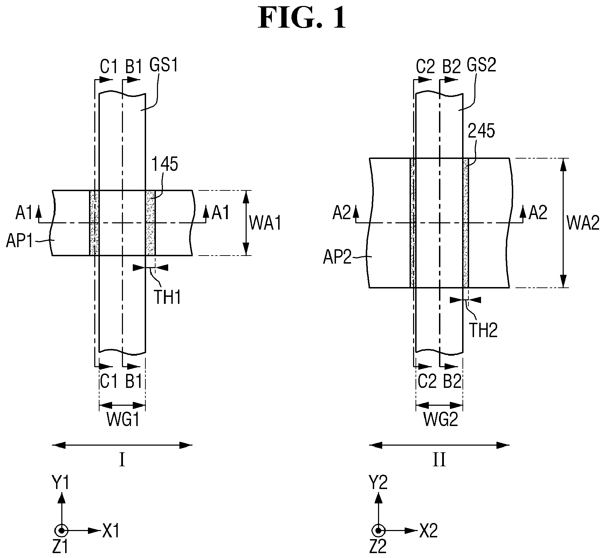

Semiconductor devices according to some implementations of the present disclosure will hereinafter be described with reference to FIGS. 1 through 22.

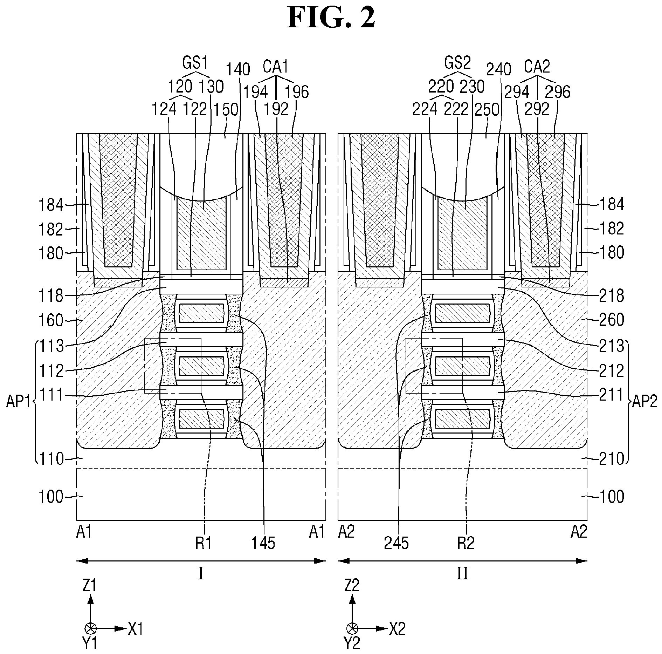

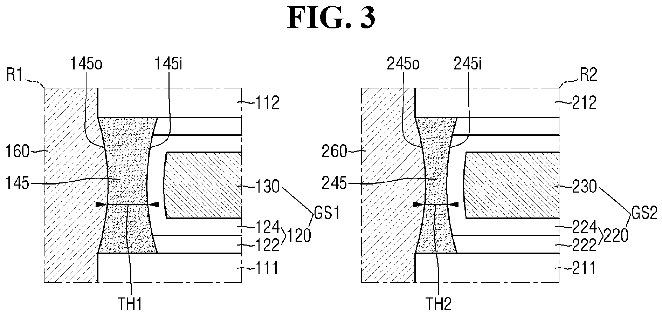

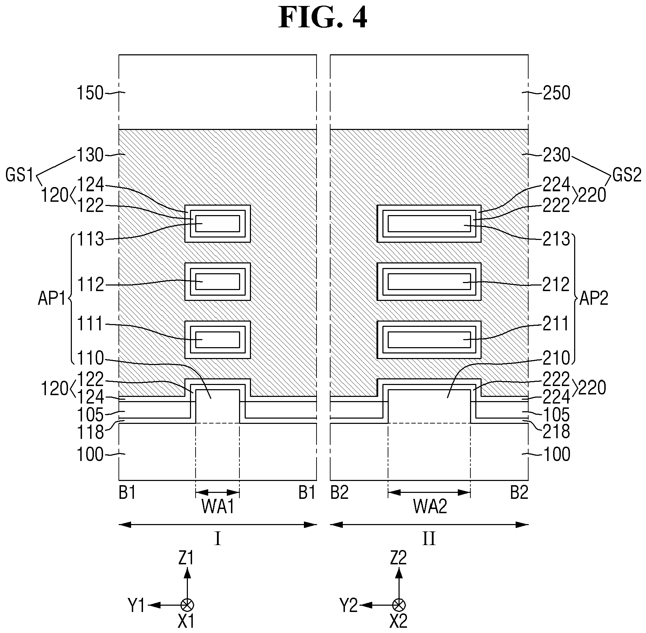

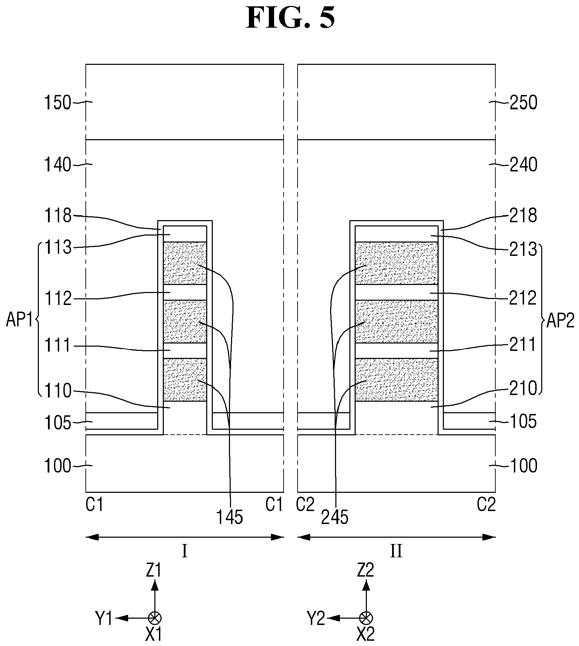

FIG. 1 is a layout view of an example of a semiconductor device. FIG. 2 illustrates example cross-sectional views taken along lines A1-A1 and A2-A2 of FIG. 1. FIG. 3 illustrates example enlarged cross-sectional views of regions R1 and R2 of FIG. 2. FIG. 4 illustrates example cross-sectional views taken along lines B1-B1 and B2-B2 of FIG. 1. FIG. 5 illustrates example cross-sectional views taken along lines C1-C1 and C2-C2 of FIG. 1.

Referring to FIGS. 1 through 5, the semiconductor device may include a substrate 100, a field insulating film 105, a first active pattern AP1, a second active pattern AP2, a first gate structure GS1, a second gate structure GS2, first gate spacers 140, second gate spacers 240, a first gate capping pattern 150, a second gate capping pattern 250, first inner spacers 145, second inner spacers 245, first epitaxial patterns 160, second epitaxial patterns 260, an interlayer insulating film 180, first source/drain contacts CA1, and second source/drain contacts CA2.

The substrate 100 may be a bulk silicon substrate or a silicon-on-insulator (SOI) substrate. Alternatively, the substrate 100 may be a silicon substrate or may include silicon germanium, silicon germanium-on-insulator (SGOI), indium antimonide, lead tellurium compounds, indium arsenic, indium phosphide, gallium arsenic, or gallium antimonide. Alternatively, the substrate 100 may be an epitaxial layer formed on a base substrate. For convenience, the substrate 100 will hereinafter be described as being a silicon substrate.

The substrate 100 may include first and second regions I and II. The first and second regions I and II may be connected regions or separated regions. Transistors with the same conductivity type or with different conductivity types may be formed in both the first and second regions I and II.

The first active pattern AP1 may be formed on the first region I of the substrate 100. The first active pattern AP1 may extend in a first direction X1, which is parallel to the upper surface of the substrate 100. The first active pattern AP1 may include a plurality of bridge patterns (e.g., first, second, and third bridge patterns 111, 112, and 113), which are sequentially stacked on the upper surface of the substrate 100 and are spaced apart from one another, extending in a first direction X1. The first active pattern AP1 may be used as the channel region of a multi-bridge channel field-effect transistor (MBCFET^{™}). The number of bridge patterns included in the first active pattern AP1 is merely an example and is not particularly limited.

In some implementations, the first active pattern AP1 may further include a first fin pattern 110. The first fin pattern 110 may protrude from the upper surface of the substrate 100 and may extend in the first direction X1. The first fin pattern 110 may be formed by etching part of the substrate 100 and may be an epitaxial layer grown from the substrate 100. The first, second, and third bridge patterns 111, 112, and 113 may be sequentially stacked on the upper surface of the first fin pattern 110.

The second active pattern AP2 may be formed on the second region II of the substrate 100. The second active pattern AP2 may extend in a fourth direction X2, which is parallel to the upper surface of the substrate 100. The fourth direction X2 may be the same as the first direction X1, but the present disclosure is not limited thereto. Alternatively, the fourth direction X2 may be different from the first active pattern X1. The second active pattern Ap2 may include a plurality of bridge patterns (e.g., fourth, fifth, and sixth bridge patterns 211, 212, and 213), which are sequentially stacked on the upper surface of the substrate 100 and are spaced apart from one another, extending in the fourth direction X2. The second active pattern AP2 may be used as the channel region of an MBCFET^{™} The number of bridge patterns included in the second active pattern AP2 is merely an example and is not particularly limited.

In some implementations, the second active pattern AP2 may further include a second fin pattern 210. The second fin pattern 210 may protrude from the upper surface of the substrate 100 and may extend in the fourth direction X2. The second fin pattern 210 may be formed by etching part of the substrate 100 and may be an epitaxial layer grown from the substrate 100. The fourth, fifth, and sixth bridge patterns 211, 212, and 213 may be sequentially stacked on the upper surface of the second fin pattern 210.

A first width WA1 of the first active pattern AP1 may be less than a second width WA2 of the second active pattern AP2. Here, the first width WA1 refers to the measurement taken in a second direction Y1, which intersects the extension direction of the first active pattern AP1, i.e., the first direction X1, and the second width WA2 refers to the measurement taken in a fifth direction Y2, which intersects the extension direction of the second active pattern AP2, i.e., the fourth direction X2. For example, the first width WA1 may be about 5 nm to about 20 nm, and the second width WA2 may be about 20 nm to about 100 nm. The fifth direction Y2 may be the same as the second direction Y1, but the present disclosure is not limited thereto. The fifth direction Y2 may be different from the second direction Y1.

FIGS. 4 and 5 illustrate that the first width WA1 of the first active pattern AP1 is uniform along a height direction (i.e., a third direction Z1), but the present disclosure is not limited thereto. Alternatively, the first width WA1 of the first active pattern AP1 may decrease in a direction away from the substrate 100 depending on the characteristics of an etching (or patterning) process for forming the first active pattern AP1. For example, contrary to what is depicted, the width of the first bridge pattern 111 may be less than the width of the first fin pattern 110, the width of the second bridge pattern 112 may be less than the width of the first bridge pattern 111, and the width of the third bridge pattern 113 may be less than the width of the second bridge pattern 112.

Also, FIGS. 4 and 5 illustrate that the second width WA2 of the second active pattern AP2 is uniform along a height direction (i.e., a sixth direction Z2), but the present disclosure is not limited thereto. Alternatively, the second width WA2 of the second active pattern AP2 may decrease in a direction away from the substrate 100 depending on the characteristics of an etching (or patterning) process for forming the second active pattern AP2. For example, contrary to what is depicted, the width of the fourth bridge pattern 211 may be less than the width of the second fin pattern 210, the width of the fifth bridge pattern 212 may be less than the width of the fourth bridge pattern 211, and the width of the sixth bridge pattern 213 may be less than the width of the fifth bridge pattern 212. The sixth direction Z2 may be the same as the third direction Z1, but the present disclosure is not limited thereto. Alternatively, the sixth direction Z2 may be different from the third direction Z1.

The first and second active patterns AP1 and AP2 may include an element semiconductor material, such as silicon (Si) or germanium (Ge). Alternatively, the first and second active patterns AP1 and AP2 may include a compound semiconductor, such as a group IV-IV compound semiconductor or a group III-V compound semiconductor. The group IV-IV compound semiconductor may be, for example, a binary compound or a ternary compound containing at least two or more of carbon (C), Si, Ge, and tin (Sn), or a compound doped with a group IV group element. The group III-V compound semiconductor may be a binary compound, a ternary compound, or a quaternary compound formed by combining at least one group III element, such as aluminum (Al), gallium (Ga), or indium (In), with at least one group V element, such as phosphorus (P), arsenic (As), or antimony (Sb). The first and second active patterns AP1 and AP2 will hereinafter be described as being, for example, Si patterns.

In some implementations, the first and second active patterns AP1 and AP2 may be arranged at the same level. Here, the phrase "arranged at the same level" means that the corresponding elements are positioned at the same height relative to the surface of the substrate 100. For example, as illustrated in FIGS. 2, 4, and 5, the first, second, and third bridge patterns 111, 112, and 113 may be arranged at the same height as the fourth, fifth, and sixth bridge patterns 211, 212, and 213, respectively.

In some implementations, the first and second active patterns AP1 and AP2 may be formed at the same level. Here, the phrase "formed at the same level" means that the corresponding elements are formed by the same manufacturing process. For example, the first and second active patterns AP1 and AP2 may be formed of the same material and/or have the same material composition.

The field insulating film 105 may be formed on the substrate 100. The field insulating film 105 may include at least one of, for example, silicon oxide, silicon nitride, silicon oxynitride, and a combination thereof, but the present disclosure is not limited thereto. For example, the field insulating film 105 may include silicon oxide films.

In some implementations, the field insulating film 105 may cover at least parts of the side surfaces of the first fin pattern 110 and at least parts of the side surfaces of the second fin pattern 210. FIGS. 4 and 5 illustrate that upper portions of the first and second fin patterns 110 and 210 protrude beyond the upper surface of the field insulating film 105, but the present disclosure is not limited thereto. Alternatively, the upper surface of the field insulating film 105 may be coplanar with the upper surfaces of the first and second fin patterns 110 and 210.

The first gate structure GS1 may be formed on the first region I of the substrate 100 and the field insulating film 105. The first gate structure GS1 may intersect the first active pattern AP1. For example, the first gate structure GS1 may extend in the second direction Y1, which is parallel to the upper surface of the substrate 100 and intersects the first direction X1. The first, second, and third bridge patterns 111, 112, and 113 may penetrate the first gate structure GS1 by extending in the first direction X1. That is, the first gate structure GS1 may surround each of the first, second, and third bridge patterns 111, 112, and 113.

The second gate structure GS2 may be formed on the second region II of the substrate 100 and the field insulating film 105. The second gate structure GS2 may intersect the second active pattern AP2. For example, the second gate structure GS2 may extend in the fifth direction Y2, which is parallel to the upper surface of the substrate 100 and intersects the fourth direction X2. The fourth, fifth, and sixth bridge patterns 211, 212, and 213 may penetrate the second gate structure GS2 by extending in the fourth direction X2. That is, the second gate structure GS2 may surround each of the fourth, fifth, and sixth bridge patterns 211, 212, and 213.

In some implementations, a third width WG1 of the first gate structure GS1 may be the same as a fourth width WG2 of the second gate structure GS2. Here, the third width WG1 refers to the measurement taken in the first direction X1, which intersects the extension direction of the first gate electrode GS1, i.e., the second direction Y1, and the fourth width WG2 refers to the measurement taken in the fourth direction X2, which intersects the extension direction of the second gate structure GS2, i.e., the fifth direction Y2.

The first gate structure GS1 may include a first gate dielectric film 120 and a first gate electrode 130, and the second gate structure GS2 may include a second gate dielectric film 220 and a second gate electrode 230.

The first gate dielectric film 120 may be stacked on the first active pattern AP1. The first gate dielectric film 120 may surround the first active pattern AP1. The first gate dielectric film 120 may extend along the upper surface of the field insulating film 105 and the surfaces of the first fin pattern 110, which protrudes from the field insulating film 105.

The second gate dielectric film 220 may be stacked on the second active pattern AP2. The second gate dielectric film 220 may surround the second active pattern AP2. The second gate dielectric film 220 may extend along the upper surface of the field insulating film 105 and the surfaces of the second fin pattern 210, which protrudes from the field insulating film 105.

The first and second gate dielectric films 120 and 220 may include at least one of, for example, silicon oxide, silicon oxynitride, silicon nitride, and a high-k material with a greater dielectric constant than silicon oxide. The high-k material may include at least one of, for example, hafnium oxide (HfO₂), zirconium oxide (ZrO₂), lanthanum oxide (La₂O₃), aluminum oxide (Al₂O₃), titanium oxide (TiO₂), strontium oxide (SrTiO₃), lanthanum aluminum oxide (LaAlO₃), yttrium oxide(Y₂O₃), hafnium oxynitride (HfOₓN_{y}), zirconium oxynitride (ZrOₓN_{y}), lanthanum oxynitride (La₂OₓN_{y}), aluminum oxynitride (Al₂OₓN_{y}), titanium oxynitride (TiOₓN_{y}), strontium titanium oxynitride (SrTiOₓN_{y}), lanthanum aluminum oxynitride (LaAlOₓN_{y}), yttrium oxynitride (Y₂OₓN_{y}), and a combination thereof, but the present disclosure is not limited thereto.

In some implementations, the first gate dielectric film 120 may include a first interfacial film 122 and a first high-k film 124, which are sequentially stacked on the first active pattern AP1. In some implementations, the second gate dielectric film 220 may include a second interfacial film 222 and a second high-k film 224, which are sequentially stacked on the second active pattern AP2.

The first interfacial film 122 may extend conformally along the circumferences of the first, second, and third bridge patterns 111, 112, and 113. The second interfacial film 222 may extend conformally along the circumferences of the fourth, fifth, and sixth bridge patterns 211, 212, and 213. The first and second interfacial films 122 and 222 may include at least one of, for example, silicon oxide, silicon oxynitride, and silicon nitride. In some implementations, the first interfacial film 122 may include an oxide of the material included in the first active pattern AP1, and the second interfacial film 222 may include an oxide of the material included in the second active pattern AP2. For example, the first and second interfacial films 122 and 222 may include silicon oxide films.

The first high-k film 124 may extend conformally along the circumference of the first interfacial film 122. The second high-k film 224 may extend conformally along the circumference of the second interfacial film 222. The first and second high-k films 124 and 224 may include, for example, the high-k material.

The semiconductor device according to some implementations of the present disclosure may include a negative capacitance (NC) field-effect transistor (FET) using a negative capacitor. For example, each of the first and second interfacial films 122 and 222 may include a ferroelectric material film having ferroelectric properties and a paraelectric material film having paraelectric properties.

The ferroelectric material film may have a negative capacitance, and the paraelectric material film may have a positive capacitance. For example, if two or more capacitors are connected in series and have positive capacitance, the total capacitance of the two or more capacitors may be lower than the capacitance of each of the two or more capacitors. On the contrary, if at least one of the two or more capacitors has negative capacitance, the total capacitance of the two or more capacitors may have a positive value and may be greater than the absolute value of the capacitance of each of the two or more capacitors.

If the ferroelectric material film having a negative capacitance and the paraelectric material film having a positive capacitance are connected in series, the total capacitance of the ferroelectric material film and the paraelectric material film may increase. Accordingly, a transistor having the ferroelectric material film can have a sub-threshold swing (SS) of less than 60 mV/decade at room temperature.

The ferroelectric material film may have ferroelectric properties. The ferroelectric material film may include at least one of, for example, hafnium oxide, hafnium zirconium oxide, barium strontium titanium oxide, barium titanium oxide, and lead zirconium titanium oxide. For example, the hafnium zirconium oxide may be a material obtained by doping hafnium oxide with zirconium (Zr). In another example, the hafnium zirconium oxide may be a compound of hafnium (Hf), Zr, and oxygen (O).

The ferroelectric material film may further include a dopant. For example, the dopant may include at least one of Al, Ti, Nb, lanthanum (La), yttrium (Y), magnesium (Mg), silicon, calcium (Ca), cerium (Ce), dysprosium (Dy), erbium (Er), gadolinium (Gd), germanium, scandium (Sc), strontium (Sr), and tin (Sn). The type of dopant may vary depending on the type of material of the ferroelectric material film.

If the ferroelectric material film includes hafnium oxide, the dopant of the ferroelectric material film may include at least one of, for example, Gd, Si, Zr, Al, and Y.

If the dopant of the ferroelectric material film is Al, the ferroelectric material film may include about 3 atomic% (at%) to about 8 at% of Al. Here, the ratio of the dopant in the ferroelectric material film may refer to the ratio of the sum of the amounts of Hf and Al to the amount of Al in the ferroelectric material film.

If the dopant of the ferroelectric material film is Si, the ferroelectric material film may include about 2 at% to about 10 at% of Si. If the dopant of the ferroelectric material film is Y, the ferroelectric material film may include about 2 at% to about 10 at% of Y. If the dopant of the ferroelectric material film is Gd, the ferroelectric material film may include about 1 at% to about 7 at% of Gd. If the dopant of the ferroelectric material film is Zr, the ferroelectric material film may include about 50 at% to about 80 at% of Zr.

The paraelectric material film may include paraelectric properties. The paraelectric material film may include at least one of, for example, silicon oxide and a high-k metal oxide. The high-k metal oxide may include at least one of, for example, hafnium oxide, zirconium oxide, and aluminum oxide, but the present disclosure is not limited thereto.

The ferroelectric material film and the paraelectric material film may include the same material. The ferroelectric material film may have ferroelectric properties, but the paraelectric material film may not have ferroelectric properties. For example, if the ferroelectric material film and the paraelectric material film include hafnium oxide, the hafnium oxide included in the ferroelectric material film may have a different crystalline structure from the hafnium oxide included in the paraelectric material film.

The ferroelectric material film may be thick enough to exhibit ferroelectric properties. The ferroelectric material film may have a thickness of, for example, about 0.5 nm to about 10 nm, but the present disclosure is not limited thereto. A critical thickness that can exhibit ferroelectric properties may vary depending on the type of ferroelectric material, and thus, the thickness of the ferroelectric material film may vary depending on the type of ferroelectric material included in the ferroelectric material film.

For example, the first gate dielectric film 120 and/or the second gate dielectric film 220 may include one ferroelectric material film. In another example, the first gate dielectric film 120 and/or the second gate dielectric film 220 may include a plurality of ferroelectric material films that are spaced apart from one another. The first gate dielectric film 120 and/or the second gate dielectric film 220 may have a structure in which a plurality of ferroelectric material films and a plurality of paraelectric material films are stacked alternately.

The first gate electrode 130 may be formed on the substrate 100 and the field insulating film 105. The first gate electrode 130 may also be stacked on the first gate dielectric film 120. That is, the first gate dielectric film 120 may be interposed between the first active pattern AP1 and the first gate electrode 130. The first gate dielectric film 120 may also be interposed between the first fin pattern 110 and the first gate electrode 130. The first gate electrode 130 may be formed by, for example, a replacement process, but the present disclosure is not limited thereto.

The second gate electrode 230 may be formed on the substrate 100 and the field insulating film 105. The second gate electrode 230 may also be stacked on the second gate dielectric film 220. That is, the second gate dielectric film 220 may be interposed between the second active pattern AP2 and the second gate electrode 230. The second gate dielectric film 220 may also be interposed between the second fin pattern 210 and the second gate electrode 230. The second gate electrode 230 may be formed by, for example, a replacement process, but the present disclosure is not limited thereto.

The first and second gate electrodes 130 and 230 are illustrated as being single films, but the present disclosure is not limited thereto. Alternatively, the first and second gate electrodes 130 and 230 may be formed as stacks of multiple conductive layers. For example, each of the first and second gate electrodes 130 and 230 may include a work function control film for controlling a work function and a filling conductive film that fills the space formed by the work function control film. The work function control film may include at least one of, for example, TiN, TaN, TiC, TaC, TiAlC, and a combination thereof. The filling conductive film may include, for example, W or Al.

In some implementations, the first and second gate structures GS1 and GS2 may be formed at the same level.

The first gate spacers 140 may be formed on the substrate 100 and the field insulating film 105. The first gate spacers 140 may extend along the side surfaces of the first gate structure GS 1. In some implementations, parts of the first gate dielectric film 120 may be interposed between the first gate electrode 130 and the first gate spacers 140. For example, the first gate dielectric film 120 may further extend along at least parts of the inner side surfaces of the first gate spacers 140. The first gate dielectric film 120 may be formed by a replacement process, but the present disclosure is not limited thereto.

The second gate spacers 240 may be formed on the substrate 100 and the field insulating film 105. The second gate spacers 240 may extend along the side surfaces of the second gate structure GS2. In some implementations, parts of the second gate dielectric film 220 may be interposed between the second gate electrode 230 and the second gate spacers 240. For example, the second gate dielectric film 220 may further extend along at least parts of the inner side surfaces of the second gate spacers 240. The second gate dielectric film 220 may be formed by a replacement process, but the present disclosure is not limited thereto.

The first gate spacers 140 and the second gate spacers 240 may include at least one of, for example, silicon nitride, silicon oxynitride, silicon oxycarbide, silicon boron nitride, silicon boron carbonitride, silicon oxycarbonitride, and a combination thereof, but the present disclosure is not limited thereto. For example, the first gate spacers 140 and the second gate spacers 240 may include silicon nitride films. In some implementations, the first gate spacers 140 and the second gate spacers 240 may be formed at the same level.

The first gate capping pattern 150 may extend along the upper surface of the first gate structure GS1. In some implementations, the first gate capping pattern 150 may cover the upper surface of the first gate structure GS1 and the upper surfaces of the first gate spacers 140. In some implementations, the upper surface of the first gate structure GS1 and the upper surfaces of the first gate spacers 140 may include concave surfaces. The first gate capping pattern 150 may be formed on a concave surface.

The second gate capping pattern 250 may extend along the upper surface of the second gate structure GS2. In some implementations, the second gate capping pattern 250 may cover the upper surface of the second gate structure GS2 and the upper surfaces of the second gate spacers 240. In some implementations, the upper surface of the second gate structure GS2 and the upper surfaces of the second gate spacers 240 may include concave surfaces. The second gate capping pattern 250 may be formed on a concave surface.

The first and second gate capping patterns 150 and 250 may include at least one of, for example, silicon nitride, silicon oxynitride, silicon oxycarbide, silicon boron nitride, silicon boron carbonitride, silicon oxycarbonitride, and a combination thereof, but the present disclosure is not limited thereto. For example, the first and second gate capping patterns 150 and 250 may include silicon nitride films. In some implementations, the first and second gate capping patterns 150 and 250 may be formed at the same level.

The first inner spacers 145 may be formed on the side surfaces of the first gate electrode 130 between the first, second, and third bridge patterns 111, 112, and 113. The first inner spacers 145 may also be formed on the side surfaces of the first gate electrode 130 between the first fin pattern 110 and the first bridge pattern 111.

In some implementations, the first interfacial film 122 may be in contact with the first inner spacers 145. For example, as illustrated in FIG. 3, the first interfacial film 122 may extend along the surfaces of the first and second bridge patterns 111 and 112 and may be in direct contact with first inner side surfaces 145i that adjoin the first and second bridge patterns 111 and 112. The first interfacial film 122 may not extend along the first inner side surfaces 145i.

In a cross-sectional view across the first direction X1, the first gate spacers 140 may surround at least part of the first active pattern AP1 and at least parts of the first inner spacers 145. For example, as illustrated in FIG. 5, the first gate spacers 140 may cover the side surfaces of the first inner spacers 145 and/or the side surfaces and upper surface of the first active pattern AP1.

The second inner spacers 245 may be formed on the side surfaces of the second gate electrode 230 between the fourth, fifth, and sixth bridge patterns 211, 212, and 213. The second inner spacers 245 may also be formed on the side surfaces of the second gate electrode 230 between the second fin pattern 210 and the fourth bridge pattern 211.

In some implementations, the second interfacial film 222 may be in contact with the second inner spacers 245. For example, as illustrated in FIG. 3, the second interfacial film 222 may extend along the surfaces of the fourth and fifth bridge patterns 211 and 212 and may be in direct contact with second inner side surfaces 245i that adjoin the fourth and fifth bridge patterns 211 and 212. The second interfacial film 222 may not extend along the second inner side surfaces 245i.

In a cross-sectional view across the fourth direction X2, the second gate spacers 240 may surround at least part of the second active pattern AP2 and at least parts of the second inner spacers 245. For example, as illustrated in FIG. 5, the second gate spacers 240 may cover the side surfaces of the second inner spacers 245 and/or the side surfaces and upper surface of the second active pattern AP2.

The first inner spacers 145 and the second inner spacers 245 may include at least one of, for example, silicon nitride, silicon oxynitride, silicon oxycarbide, silicon boron nitride, silicon boron carbonitride, silicon oxycarbonitride, and a combination thereof, but the present disclosure is not limited thereto. In some implementations, the first inner spacers 145 and the second inner spacers 245 may be formed at the same level.

The first inner spacers 145 and the second inner spacers 245 may include the same material as or a different material from the first gate spacers 140 and the second gate spacers 240. In some implementations, the first inner spacers 145 and the second inner spacers 245 may have a smaller dielectric constant than the first gate spacers 140 and the second gate spacers 240. For example, the first gate spacers 140 and the second gate spacers 240 may include silicon nitride films, and the first inner spacers 145 and the second inner spacers 245 may include silicon oxide films.

In some implementations, a first liner film 118 may be formed on the first active pattern AP1 and the first inner spacers 145. The first liner film 118 may be interposed between the first active pattern AP1 and the first gate spacers 140 and between the first inner spacers 145 and the first gate spacers 140. For example, as illustrated in FIG. 5, the first liner film 118 may extend conformally along the upper surface of the substrate 100, the side surfaces of the first inner spacers 145, and/or the side surfaces and upper surface of the first active pattern AP1.

The first liner film 118 may not be interposed between the first active pattern AP1 and the first gate structure GS1. The field insulating film 105 may be formed on the first liner film 118.

In some implementations, a second liner film 218 may be formed on the second active pattern AP2 and the second inner spacers 245. The second liner film 218 may be interposed between the second active pattern AP2 and the second gate spacers 240 and between the second inner spacers 245 and the second gate spacers 240. For example, as illustrated in FIG. 5, the second liner film 218 may extend conformally along the upper surface of the substrate 100, the side surfaces of the second inner spacers 245, and/or the side surfaces and upper surface of the second active pattern AP2. The second liner film 218 may not be interposed between the second active pattern AP2 and the second gate structure GS2. The field insulating film 105 may be formed on the second liner film 218.

In some implementations, the first liner film 118 may be an epitaxial layer grown from the substrate 100 and the first active pattern AP1, and the second liner film 218 may be an epitaxial layer grown from the substrate 100 and the second active pattern AP2. For example, the first and second liner films 118 and 218 may include silicon oxide films.

In some implementations, the first and second liner films 118 and 218 may be formed at the same level.

In some implementations, at least one of the first and second liner films 118 and 218 may be omitted. Alternatively, contrary to what is depicted, the first gate spacers 140 may be in contact with the first active pattern AP1 and the first inner spacers 145. Alternatively, contrary to what is depicted, the second gate spacers 240 may be in contact with the second active pattern AP2 and the second inner spacers 245.

The first epitaxial patterns 160 may be formed on the upper surface of the substrate 100 and at least one side (e.g., both sides) of the first gate structure GS1. The first epitaxial patterns 160 may be connected to the first active pattern AP1. For example, the first, second, and third bridge patterns 111, 112, and 113 may be connected to the first epitaxial patterns 160 by penetrating the first gate structure GS1 and the first gate spacers 140.

The first epitaxial patterns 160 may be formed on the outer side surfaces of the first gate spacers 140 and first outer side surfaces 145o of the first inner spacers 145. That is, the first gate spacers 140 and the first inner spacers 145 may be interposed between the first gate structure GS1 and the first epitaxial patterns 160. The first epitaxial patterns 160 may be electrically isolated from the first gate electrode 130 by the first gate spacers 140 and the first inner spacers 145. In some implementations, the first epitaxial patterns 160 may be in direct contact with the outer side surfaces of the first gate spacers 140 and/or the first outer side surfaces 145o of the first inner spacers 145.

The first epitaxial patterns 160 may include epitaxial layers. For example, the first epitaxial patterns 160 may be grown from the substrate 100 and/or the first active pattern AP1 by an epitaxial growth method. The first epitaxial patterns 160 may be provided as the source/drain regions of a FET, which is formed on the first region I.

In some implementations, the uppermost surfaces of the first epitaxial patterns 160 may be formed to be at the same height as or higher than the upper surface of the third bridge pattern 113. This is due to the first epitaxial patterns 160 being formed using the epitaxial growth method from the third bridge pattern 113, which is the uppermost bridge pattern among the first, second, and third bridge patterns 111, 112, and 113.

The second epitaxial patterns 260 may be formed on the upper surface of the substrate 100 and at least one side (e.g., both sides) of the second gate structure GS2. The second epitaxial patterns 260 may be connected to the second active pattern AP2. For example, the fourth, fifth, and sixth bridge patterns 211, 212, and 213 may be connected to the second epitaxial patterns 260 by penetrating the second gate structure GS2 and the second gate spacers 240.

The second epitaxial patterns 260 may be formed on the outer side surfaces of the second gate spacers 240 and second outer side surfaces 245o of the second inner spacers 245. That is, the second gate spacers 240 and the second inner spacers 245 may be interposed between the second gate structure GS2 and the second epitaxial patterns 260. The second epitaxial patterns 260 may be electrically isolated from the second gate electrode 230 by the second gate spacers 240 and the second inner spacers 245. In some implementations, the second epitaxial patterns 260 may be in direct contact with the outer side surfaces of the second gate spacers 240 and/or the second outer side surfaces 245o of the second inner spacers 245.

The second epitaxial patterns 260 may include epitaxial layers. For example, the second epitaxial patterns 260 may be grown from the substrate 100 and/or the second active pattern AP2 by an epitaxial growth method. The second epitaxial patterns 260 may be provided as the source/drain regions of a FET, which is formed on the second region II.

In some implementations, the uppermost surfaces of the second epitaxial patterns 260 may be formed to be at the same height as or higher than the upper surface of the sixth bridge pattern 213. This is due to the second epitaxial patterns 260 being formed using the epitaxial growth method from the sixth bridge pattern 213, which is the uppermost bridge pattern among the fourth, fifth, and sixth bridge patterns 211, 212, and 213.

In a case where the FET formed on the first region I and/or the FET formed on the second region II are n-type FETs (NFETs), the first epitaxial patterns 160 and the second epitaxial patterns 260 may include n-type impurities or impurities for preventing the diffusion of n-type impurities. For example, the first epitaxial patterns 160 and/or the second epitaxial patterns 260 may include at least one of P, Sb, As, and a combination thereof.

In some implementations, the first epitaxial patterns 160 and/or the second epitaxial patterns 260 may further include a tensile stress material. For example, when the first active pattern AP1 and/or the second active pattern AP2 are Si patterns, the first epitaxial patterns 160 and/or the second epitaxial patterns 260 may include a material with a smaller lattice constant than Si, such as silicon carbide (SiC). The tensile stress material can enhance the carrier mobility in the channel region by applying tensile stress to the first active pattern AP1 and/or the second active pattern AP2.

In a case where the FET formed on the first region I and/or the FET formed on the second region II are p-type FETs (PFETs), the first epitaxial patterns 160 and/or the second epitaxial patterns 260 may include p-type impurities or impurities for preventing the diffusion of p-type impurities. For example, the first epitaxial patterns 160 and/or the second epitaxial patterns 260 may include at least one of B, In, Ga, Al, or a combination thereof.

In some implementations, the first epitaxial patterns 160 and/or the second epitaxial patterns 260 may further include a compressive stress material. For example, when the first active pattern AP1 and/or the second active pattern AP2 are Si patterns, the first epitaxial patterns 160 and/or the second epitaxial patterns 260 may include a material with a larger lattice constant than Si, such as silicon germanium (SiGe). The compressive stress material can improve the carrier mobility in the channel region by applying compressive stress to the first active pattern AP1 and/or the second active pattern AP2.

In some implementations, the first outer side surfaces 145o of the first inner spacers 145, which are opposite to the first epitaxial patterns 160, may include concave surfaces. In this case, the side surfaces of parts of the first epitaxial patterns 160 that are in contact with the first outer side surfaces 145o may include convex surfaces.

In some implementations, the second outer side surfaces 245o of the second inner spacers 245, which are opposite to the second epitaxial patterns 260, may include concave surfaces. In this case, the side surfaces of the second epitaxial patterns 260 that are in contact with the second outer side surfaces 245o may include convex surfaces.

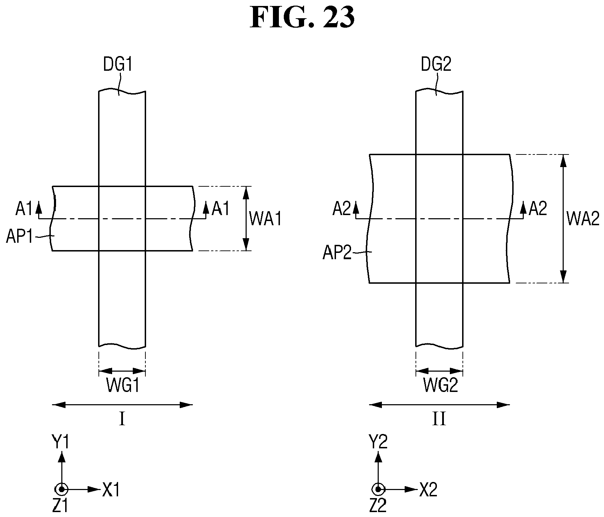

The first inner spacers 145 and the second inner spacers 245 may have different thicknesses. In some implementations, a first thickness TH1 of the first inner spacers 145 may be greater than a second thickness TH2 of the second inner spacers 245, and this is due to the first width WA1 of the first active pattern AP1, where the first inner spacers 145 are formed, being less than the second width WA2 of the second active pattern AP2, where the second inner spacers 245 are formed. Here, the first thickness TH1 refers to the measurement taken in the first direction X1, and the second thickness TH2 refers to the measurement taken in the fourth direction X2. This will be described later with reference to FIGS. 23 through 31.

The first and second thicknesses TH1 and TH2 may be defined as the measurements taken at the same height from the upper surface of the substrate 100. Alternatively, the first and second thicknesses TH1 and TH2 may be defined as the minimum thickness of the first inner spacers 145 and the minimum thickness of the second inner spacers 245, respectively. Yet alternatively, the first and second thicknesses TH1 and TH2 may be defined as the maximum thickness of the first inner spacers 145 and the maximum thickness of the second inner spacers 245, respectively.

In some implementations, the first inner side surfaces 145i of the first inner spacers 145, which are opposite to the first gate structure GS1, may include concave surfaces. In this case, the side surfaces of parts of the first gate structure GS1 that are in contact with the first inner side surfaces 145i may include convex surfaces.

In some implementations, the second inner side surfaces 245i of the second inner spacers 245, which are opposite to the second gate structure GS2, may include concave surfaces. In this case, the side surfaces of parts of the second gate structure GS2 that are in contact with the second inner side surfaces 245i may include convex surfaces.

In some implementations, the first thickness TH1 of the first inner spacers 145 may decrease in a direction away from the substrate 100 and the first active pattern AP1. For example, as illustrated in FIG. 3, the first outer side surfaces 145o and the first inner side surfaces 145i of the first inner spacers 145 may both include concave surfaces. In this case, the first thickness TH1 of the first inner spacers 145 may decrease in a direction away from the first and second bridge patterns 111 and 112. That is, the first thickness TH1 of the first inner spacers 145 may decrease to a certain point and then increase along a direction away from the first bridge pattern 111. The first outer side surfaces 145o and the first inner side surfaces 145i may have the same curvature radius, but the present disclosure is not limited thereto. Alternatively, the first outer side surfaces 145o and the first inner side surfaces 145i may have different curvature radiuses.

In some implementations, the second thickness TH2 of the second inner spacers 245 may decrease in a direction away from the substrate 100 and the second active pattern AP2.

For example, as illustrated in FIG. 3, the second outer side surfaces 245o and the second inner side surfaces 245i of the second inner spacers 245 may both include concave surfaces. In this case, the second thickness TH2 of the second inner spacers 245 may decrease in a direction away from the fourth and fifth bridge patterns 211 and 212. That is, the second thickness TH2 of the second inner spacers 245 may decrease to a certain point and then increase along a direction away from the fourth bridge pattern 211. The second outer side surfaces 245o and the second inner side surfaces 245i may have the same curvature radius, but the present disclosure is not limited thereto. Alternatively, the second outer side surfaces 245o and the second inner side surfaces 245i may have different curvature radiuses.

As illustrated in FIG. 3, the first inner side surfaces 145i and the second inner side surfaces 245i may have the same curvature radius, but the present disclosure is not limited thereto. Alternatively, the first inner side surfaces 145i and the second inner side surfaces 245i may have different curvature radiuses. For example, the first inner side surfaces 145i may have a greater curvature radius than the second inner side surfaces 245i. In another example, the first inner side surfaces 145i may have a smaller curvature radius than the second inner side surfaces 245i.

Also, as illustrated in FIG. 3, the first outer side surfaces 145o and the second outer side surfaces 245o may have the same curvature radius, but the present disclosure is not limited thereto. Alternatively, the first outer side surfaces 145o and the second outer side surfaces 245o may have different curvature radiuses. For example, the first outer side surfaces 145o may have a greater curvature radius than the second outer side surfaces 245o. In another example, the first outer side surfaces 145o may have a smaller curvature radius than the second outer side surfaces 245o.

The interlayer insulating film 180 may be formed on the substrate 100 and the field insulating film 105. The interlayer insulating film 180 may be formed to fill the spaces on the outer side surfaces of the first gate spacers 140 and the spaces on the outer side surfaces on the second gate spacers 240. For example, the interlayer insulating film 180 may cover the field insulating film 105, the first epitaxial patterns 160, and the second epitaxial patterns 260. The interlayer insulating film 180 may expose the upper surfaces of the first and second gate capping patterns 150 and 250, but the present disclosure is not limited thereto. Alternatively, the interlayer insulating film 180 may cover the upper surfaces of the first and second gate capping patterns 150 and 250.

The interlayer insulating film 180 may include at least one of, for example, silicon oxide, silicon nitride, silicon oxynitride, silicon oxycarbide, silicon boron nitride, silicon boron carbonitride, silicon oxycarbonitride, and a low-k material with a smaller dielectric constant than silicon oxide, but the present disclosure is not limited thereto. The low-k material may include at least one of, for example, flowable oxide (FOX), Torene SilaZane (TOSZ), undoped silica glass (USG), borosilicate glass (BSG), phosphosilicate glass (PSG), borophosphosilicate glass (BPSG), plasma enhanced tetra ethyl ortho silicate (PETEOS), fluoride silicate glass (FSG), carbon doped silicon oxide (CDO), Xerogel, Aerogel, amorphous fluorinated carbon, organo silicate glass (OSG), parylene, bis-benzocyclobutene (BCB), SiLK, polyimide, a porous polymeric material, and a combination thereof, but the present disclosure is not limited thereto.

In some implementations, an etch stopper film 182, which covers the first epitaxial patterns 160 and the second epitaxial patterns 260, may be formed. The etch stopper film 182 may extend conformally along the profiles of the surfaces of the first epitaxial patterns 160 and the profiles of the surfaces of the second epitaxial patterns 260. The etch stopper film 182 may further extend along the upper surface of the field insulating film 105, the side surfaces of the first gate spacers 140, and the side surfaces of the second gate spacers 240. The interlayer insulating film 180 may be formed on the etch stopper films 182.

The etch stopper film 182 may include a material with etching selectivity with respect to the interlayer insulating film 180. For example, in a case where the interlayer insulating film 180 includes silicon oxide, the etch stopper film 182 may include at least one of silicon nitride (SiN), silicon oxynitride (SiON), silicon oxycarbonitride (SiOCN), silicon boron nitride (SiBN), silicon boron oxynitride (SiOBN), silicon oxycarbide (SiOC), and a combination thereof. The etch stopper film 182 may be prepared for an etching process for the interlayer insulating film 180.

The first source/drain contacts CA1 may be connected to the first epitaxial patterns 160. For example, the first source/drain contacts CA1 may penetrate the interlayer insulating film 180 and the etch stopper film 182 by extending in the third direction Z1, and may be connected to the first epitaxial patterns 160.

The second source/drain contacts CA2 may be connected to the second epitaxial patterns 260. For example, the second source/drain contacts CA2 may penetrate the interlayer insulating film 180 and the etch stopper film 182 by extending in the sixth direction Z2, and may be connected to the second epitaxial patterns 260.

In some implementations, contact spacers 184 may be further formed on the interlayer insulating film 180 and the etch stopper film 182. The contact spacers 184 may extend conformally along the profiles of the side surfaces of the first source/drain contacts CA1 and the profiles of the side surfaces of the second source/drain contacts CA2. The first source/drain contacts CA1 and the second source/drain contacts CA2 may be connected to the first epitaxial patterns 160 and the second epitaxial patterns 260, respectively, by penetrating the contact spacers 184.

The contact spacers 184 may include at least one of, for example, silicon oxide, silicon nitride, silicon oxynitride, silicon oxycarbide, silicon boron nitride, silicon boron carbonitride, silicon oxycarbonitride, and a low-k material with a smaller dielectric constant than silicon oxide, but the present disclosure is not limited thereto.

In some implementations, each of the first source/drain contacts CA1 may include a first silicide film 192, a first barrier metal film 194, and a first metal film 196, which are sequentially stacked on the corresponding first epitaxial pattern 160. In some implementations, each of the second source/drain contacts CA2 may include a second silicide film 292, a second barrier metal film 294, and a second metal film 296, which are sequentially stacked on the corresponding second epitaxial pattern 260.

The first silicide film 192 may be interposed between the first epitaxial patterns 160 and the first barrier metal film 194, and the second silicide film 292 may be interposed between the second epitaxial patterns 260 and the second barrier metal film 294. The first and second silicide films 192 and 292 may include a metal silicide, such as nickel silicide, cobalt silicide, tungsten silicide, titanium silicide, niobium silicide, or tantalum silicide, but the present disclosure is not limited thereto. For example, the first and second silicide films 192 and 292 may include titanium silicide.

The first barrier metal film 194 may be formed on the first silicide film 192. The first barrier metal film 194 may extend conformally along the profile of the upper surface of the first silicide film 192 and the profiles of the side surfaces of the contact spacers 184. The second barrier metal film 294 may be formed on the second silicide film 292. The second barrier metal film 294 may extend conformally along the profile of the upper surface of the second silicide film 292 and the profiles of the side surfaces of the contact spacers 184. The first and second barrier metal films 194 and 294 may include a conductive metal nitride, such as titanium nitride, tantalum nitride, or tungsten nitride, but the present disclosure is not limited thereto. For example, the first and second barrier metal films 194 and 294 may include titanium nitride.

The first metal film 196 may be formed on the first barrier metal film 194. The first metal film 196 may fill the remaining area on the first silicide film 192 that is not occupied by the first barrier metal film 194. The second metal film 296 may be formed on the second barrier metal film 294. The second metal film 296 may fill the remaining area on the second silicide film 292 that is not occupied by the second barrier metal film 294. The first and second metal films 196 and 296 may include a metal material, such as cobalt (Co), titanium (Ti), tantalum (Ta), ruthenium (Ru), tungsten (W), or cobalt tungsten phosphide (CoWP), but the present disclosure is not limited thereto. For example, the first and second metal films 196 and 296 may include Co.

In some implementations, the first silicide film 192 may be formed as a result of the reaction of an element included in the first barrier metal film 194 with the corresponding first epitaxial pattern 160, and the second silicide film 292 may be formed as a result of the reaction of an element included in the second barrier metal film 294 with the corresponding second epitaxial pattern 260.

In some implementations, the first source/drain contacts CA1 and the second source/drain contacts CA2 may be formed at the same level.

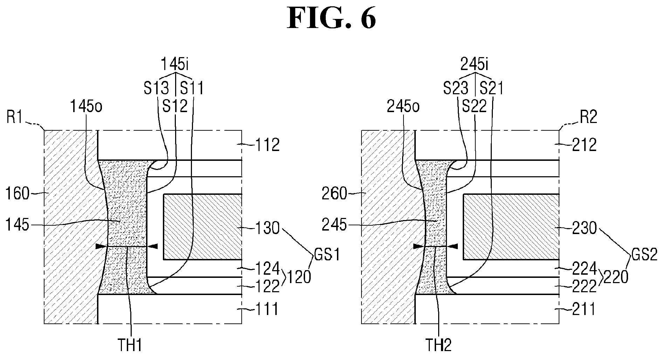

FIGS. 6 through 8 are enlarged cross-sectional views of an example of a semiconductor device. For convenience, redundant or repetitive portions that overlap with the content described earlier with reference to FIGS. 1 through 5 will be briefly mentioned or omitted.

Referring to FIG. 6, a first inner side surface 145i of a first inner spacer 145 and/or a second inner surface 245i of a second inner spacer 245 may include flat surfaces.

For example, the first inner spacer 145 may include first, second, and third surfaces S11, S12, and S13. The first surface S11 may be part of the first inner side surface 145i near a first bridge pattern 111, the third surface S13 may be part of the first inner side surface 145i near a second bridge pattern 112, and the second surface S12 may be part of the first inner side surface 145i connecting the first and third surfaces S11 and S13. In some implementations, the first and third surfaces S11 and S13 may include concave surfaces, and the second surface S12 may include a flat surface. In this case, a side surface of a first gate structure GS1 that is in contact with the third surface S13 may include a flat surface.

For example, the second inner spacer 245 may include fourth, fifth, and sixth surfaces S21, S22, and S23. The fourth surface S21 may be part of the second inner side surface 245i near a fourth bridge pattern 211, the sixth surface S23 may be part of the second inner side surface 245i near a fifth bridge pattern 212, and the second surface S12 may be part of the second inner side surface 245i connecting the fourth and sixth surfaces S21 and S23. In some implementations, the fourth and sixth surfaces S21 and S23 may include concave surfaces, and the fifth surface S22 may include a flat surface. In this case, a side surface of a second gate structure GS2 that is in contact with the sixth surface S23 may include a flat surface.

FIG. 6 illustrates that the first and second inner side surfaces 145i and 245i both include flat surfaces, but the present disclosure is not limited thereto. Alternatively, one of the first and second inner side surfaces 145i and 245i may not include a flat surface.

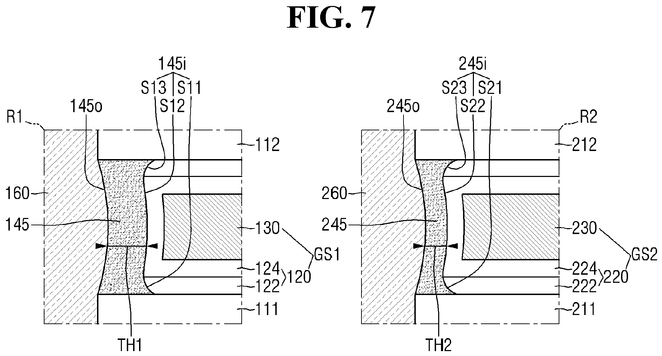

Referring to FIG. 7, the first and second inner side surfaces 145i and 245i may include convex surfaces.

For example, the first and third surfaces S11 and S13 may include concave surfaces, and the second surface S12 may include a convex surface. In this example, the side surface of the first gate structure GS1 that is in contact with the second surface S12 may include a concave surface.

For example, the fourth and sixth surfaces S21 and S23 may include concave surfaces, and the fifth surface S22 may include a convex surface. In this example, the side surface of the second gate structure GS2 that is in contact with the fifth surface S22 may include a concave surface.

FIG. 7 illustrates that the first and second inner side surfaces 145i and 245i both include convex surfaces, but the present disclosure is not limited thereto. Alternatively, one of the first and second inner side surfaces 145i and 245i may not include a convex surface.

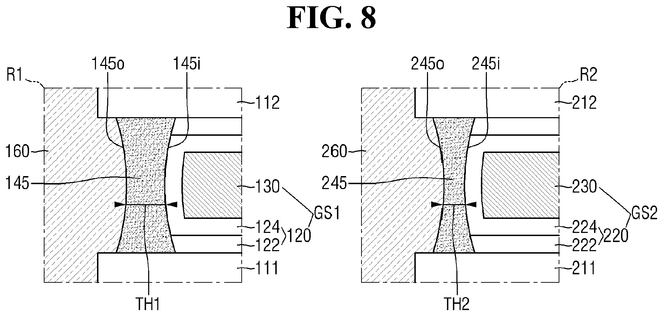

Referring to FIG. 8, the first inner spacer 145 may expose part of the horizontal plane of a first active pattern AP1, and the second inner spacer 245 may expose part of the horizontal plane of a second active pattern AP2.

For example, the first inner spacer 145 may expose part of the upper surface of the first bridge pattern 111 and part of the bottom surface of the second bridge pattern 112. The horizontal plane of the first active pattern AP1, exposed by the first inner spacer 145, may be in direct contact with the first epitaxial patterns 160.

For example, the second inner spacer 245 may expose part of the upper surface of the fourth bridge pattern 211 and part of the bottom surface of the fifth bridge pattern 212. The horizontal plane of the second active pattern AP2, exposed by the second inner spacer 245, may be in direct contact with the second epitaxial patterns 260.

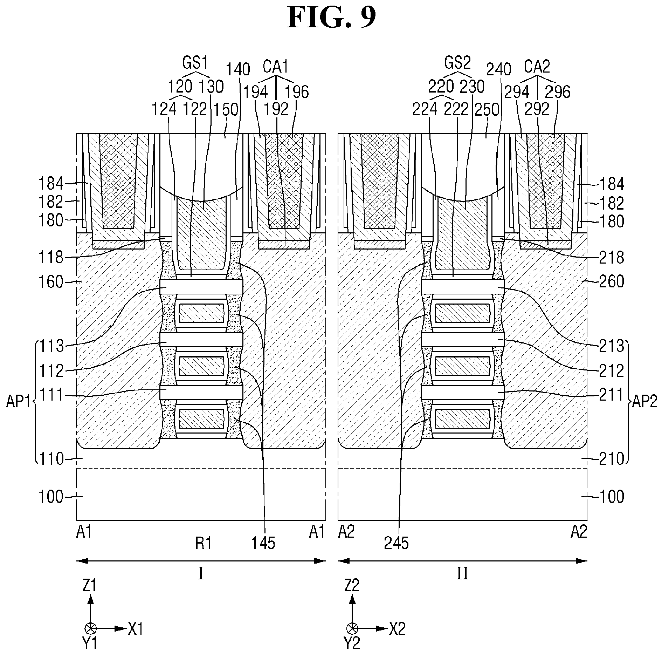

FIG. 9 illustrates cross-sectional views of an example of a semiconductor device. For convenience, redundant or repetitive portions that overlap with the content described earlier with reference to FIGS. 1 through 8 will be briefly mentioned or omitted.

Referring to FIG. 9, first inner spacers 145 and second inner spacers 245 may be further formed on uppermost bridge patterns (i.e., third and sixth bridge patterns 113 and 213).

For example, the first inner spacers 145 may be formed not only between a first bridge pattern 111, a second bridge pattern 112, and the third bridge pattern 113 and between a first fin pattern 110 and the first bridge pattern 111, but also on the upper surface of the third bridge pattern 113. The first inner spacers 145 that are positioned on the upper surface of the third bridge pattern 113 will hereinafter be referred to as uppermost first inner spacers 145. The uppermost first inner spacers 145 may be interposed between the third bridge pattern 113 and first gate spacers 140. In some implementations, a first liner film 118 may be interposed between the uppermost first inner spacers 145 and the first gate spacers 140.

For example, the second inner spacers 245 may be formed not only between a fourth bridge pattern 211, a fifth bridge pattern 212, and the sixth bridge pattern 213 and between a second fin pattern 210 and the fourth bridge pattern 211, but also on the upper surface of the sixth bridge pattern 213. The second inner spacers 245 that are positioned on the upper surface of the sixth bridge pattern 213 will hereinafter be referred to as uppermost second inner spacers 245. The uppermost second inner spacers 245 may be interposed between the sixth bridge pattern 213 and second gate spacers 240. In some implementations, a second liner film 218 may be interposed between the uppermost second inner spacers 245 and the second gate spacers 240.

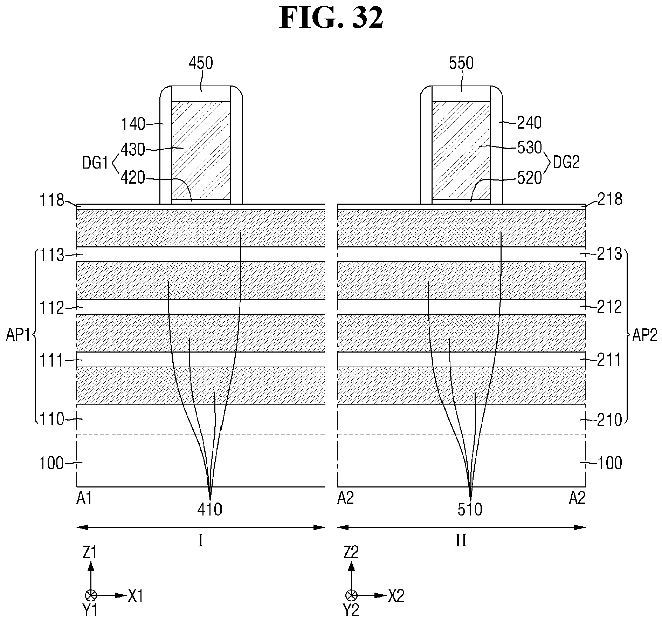

In some implementations, the uppermost surfaces of first epitaxial patterns 160 may be formed to be at the same height as or higher than the upper surfaces of the uppermost first inner spacers 145, and the uppermost surfaces of second epitaxial patterns 260 may be formed to be at the same height as or higher than the upper surfaces of the uppermost second inner spacers 245. This will be described later with reference to FIGS. 32 through 34.

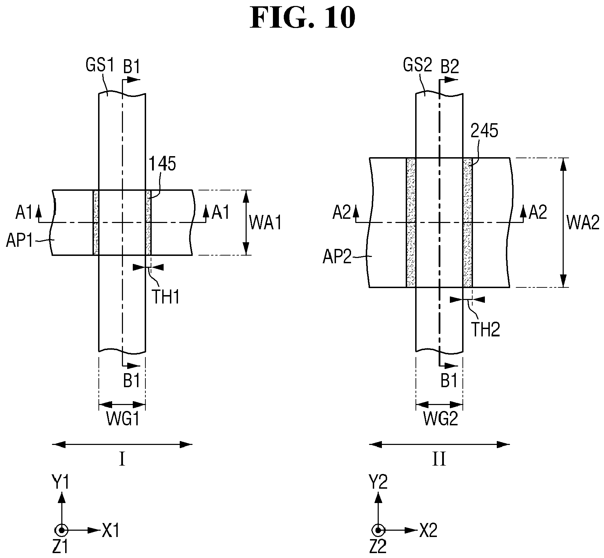

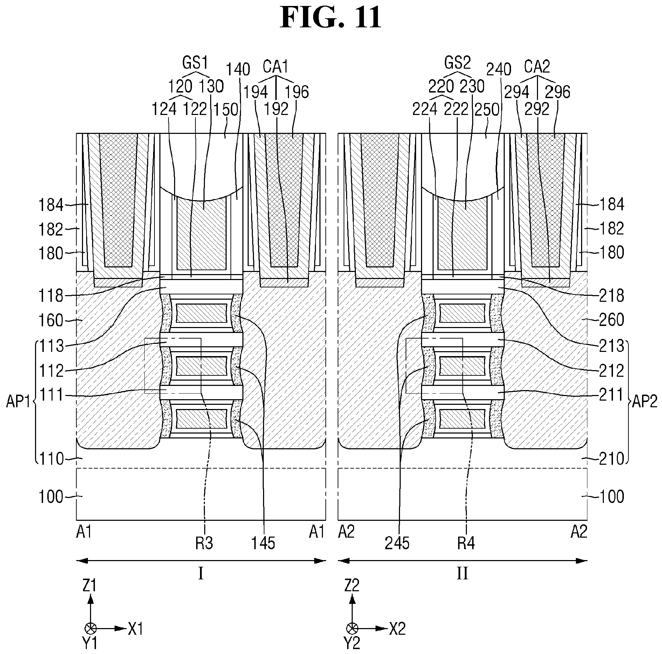

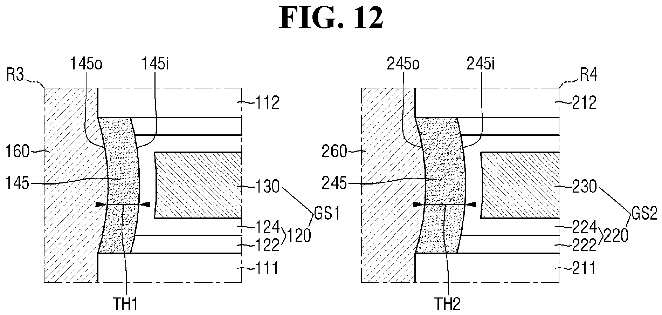

FIG. 10 is a layout view of another example of a semiconductor device. FIG. 11 illustrates example cross-sectional views taken along lines A1-A1 and A2-A2 of FIG. 10. FIG. 12 illustrates example enlarged cross-sectional views of regions R3 and R4 of FIG. 11. For convenience, redundant or repetitive portions that overlap with the content described earlier with reference to FIGS. 1 through 9 will be briefly mentioned or omitted.

Referring to FIGS. 10 through 12, a first thickness TH1 of first inner spacers 145 may be less than a second thickness TH2 of second inner spacers 245.

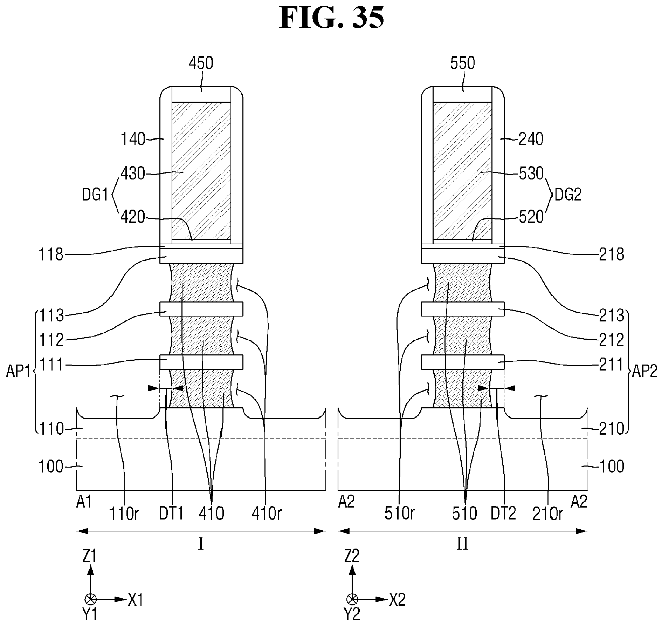

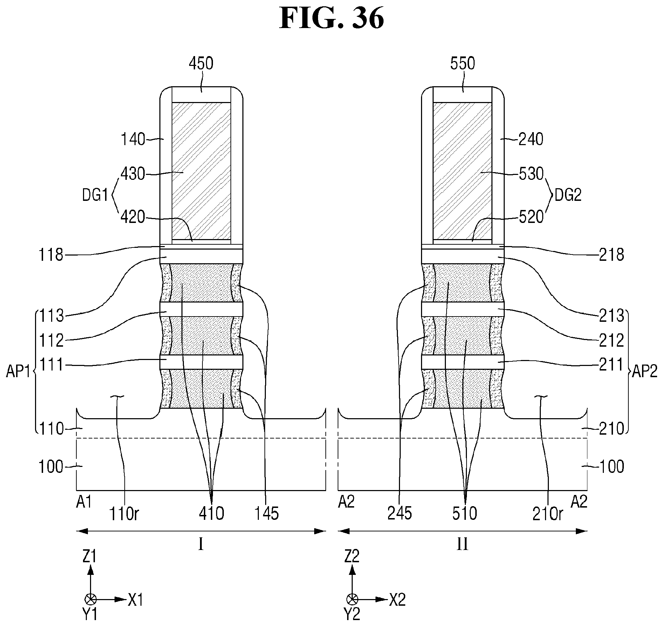

This is due to a first width WA1 of a first active pattern AP1, where the first inner spacers 145 are formed, being less than a second width WA2 of a second active pattern AP2, where the second inner spacers 245 are formed. A detailed explanation of this comparison will be provided later in FIGS. 35 and 36.

In some implementations, first inner side surfaces 145i of the first inner spacers 145, which are opposite to a first gate structure GS1, may include convex surfaces. In this case, the side surfaces of parts of the first gate structure GS1 that are in contact with the first inner side surfaces 145i may include concave surfaces. First outer side surfaces 145o and the first inner side surfaces 145i of the first inner spacers 145 may have the same curvature radius, but the present disclosure is not limited thereto. Alternatively, the first outer side surfaces 145o and the first inner side surfaces 145i may have different curvature radiuses.

In some implementations, second inner side surfaces 245i of the second inner spacers 245, which are opposite to a second gate structure GS2, may include convex surfaces.

In this case, the side surfaces of parts of the second gate structure GS2 that are in contact with the second inner side surfaces 245i may include concave surfaces. Second outer side surfaces 245o and the second inner side surfaces 245i of the second inner spacers 245 may have the same curvature radius, but the present disclosure is not limited thereto. Alternatively, the second outer side surfaces 245o and the second inner side surfaces 245i may have different curvature radiuses.

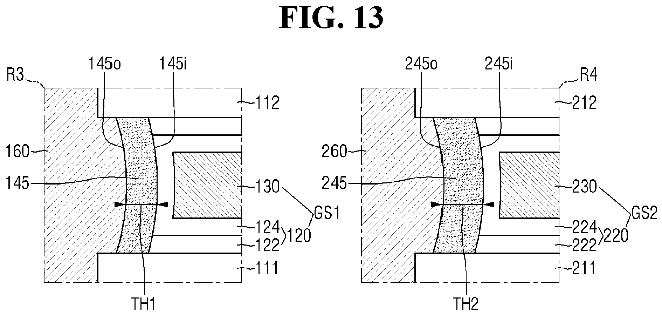

FIG. 13 illustrates enlarged cross-sectional views of another example of a semiconductor device. For convenience, redundant or repetitive portions that overlap with the content described earlier with reference to FIGS. 1 through 12 will be briefly mentioned or omitted.

Referring to FIG. 13, a first inner spacer 145 may expose part of the horizontal plane of a first active pattern AP1, and a second inner spacer 245 may expose part of the horizontal plane of a second active pattern AP2. The first and second inner spacers 145 and 245 are the same as their respective counterparts of FIG. 8, and thus, detailed descriptions thereof will be omitted.

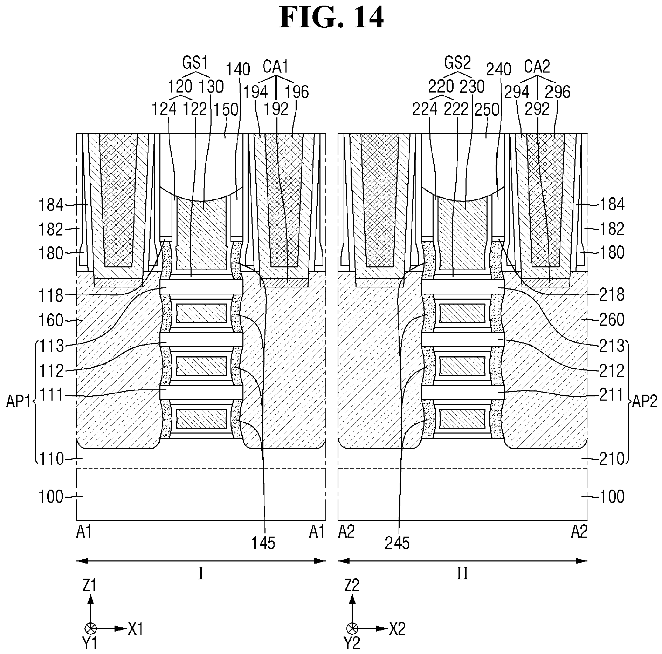

FIG. 14 illustrates cross-sectional views of another example of a semiconductor device. For convenience, redundant or repetitive portions that overlap with the content described earlier with reference to FIGS. 1 through 13 will be briefly mentioned or omitted.

Referring to FIG. 14, first inner spacers 145 and second inner spacers 245 may be further formed on uppermost bridge patterns (i.e., third and sixth bridge patterns 113 and 213). The first inner spacers 145 and the second inner spacers 245 are similar to their respective counterparts of FIG. 9, and thus, detailed descriptions thereof will be omitted.

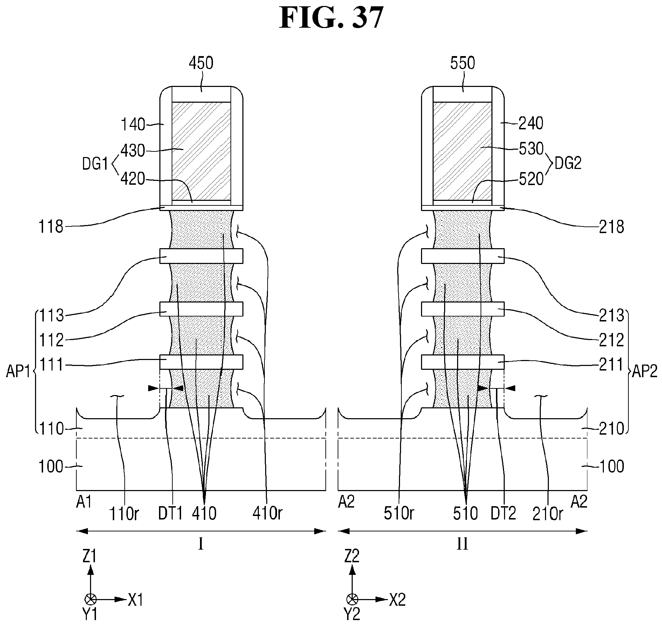

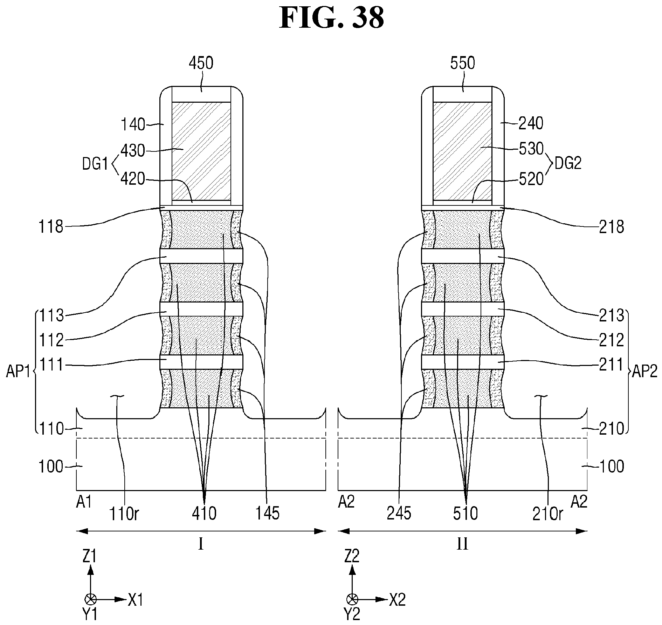

In some implementations, the uppermost surfaces of first epitaxial patterns 160 may be formed to be lower than the upper surfaces of the uppermost first inner spacers 145, and the uppermost surfaces of second epitaxial patterns 260 may be formed to be lower than the upper surfaces of the uppermost second inner spacers 245. This will be described later with reference to FIGS. 37 and 38.

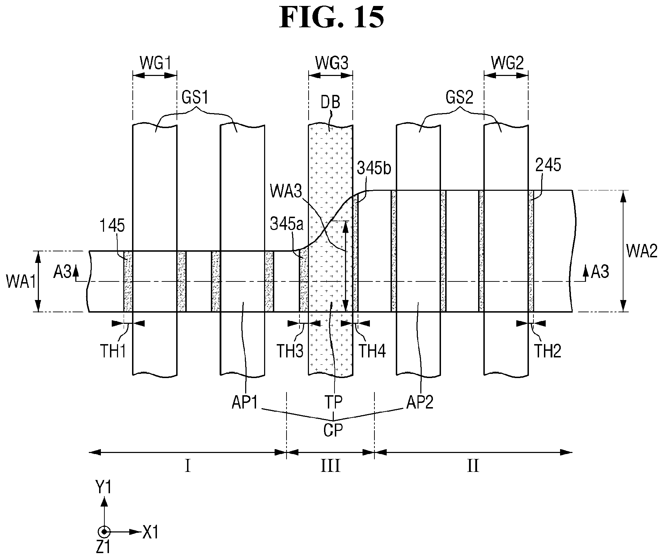

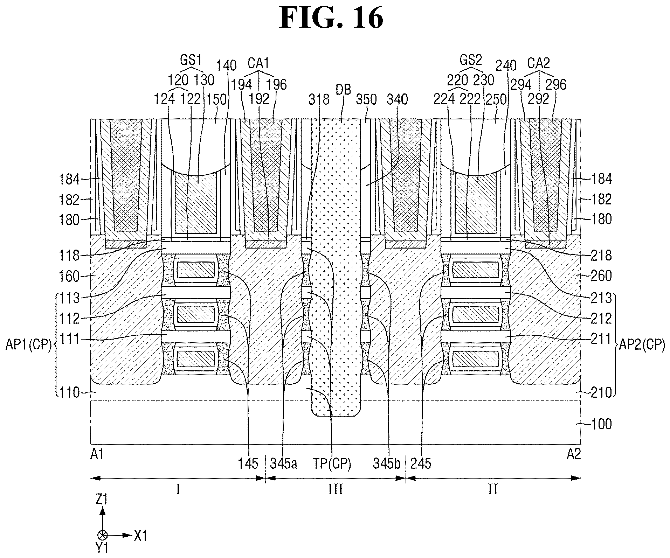

FIG. 15 is a layout view of another example of a semiconductor device. FIG. 16 is an example cross-sectional view taken along line A3-A3 of FIG. 15. For convenience, redundant or repetitive portions that overlap with the content described earlier with reference to FIGS. 1 through 14 will be briefly mentioned or omitted.

Referring to FIGS. 15 and 16, the semiconductor device may include a channel structure CP.

The channel structure CP may include first active patterns AP1, second active patterns AP2, and a transition pattern TP. The transition pattern TP may connect the first active patterns AP1 and the second active patterns AP2 in a first direction X1, in which the first active patterns AP1 and the second active patterns AP2 extend. For example, first and second regions I and II may be arranged along the first direction X1, and a substrate 100 may further include a third region III, which is interposed between the first and second regions I and II. That is, the first, third, and second regions I, III, and II may be sequentially arranged along the first direction X1 and connected to one another. The transition pattern TP may be formed on the third region III and may connect the first active patterns AP1 and the second active patterns AP2.

In some implementations, a fifth width WA3 of the transition pattern TP may increase in a direction from the first active patterns AP1 to the second active patterns AP2.

In some implementations, a first side surface of the transition pattern TP may be aligned with first side surfaces of the first active patterns AP1 and first side surfaces of the second active patterns AP2. For example, as illustrated in FIG. 15, the first side surfaces of the first active patterns AP1, the first side surface of the transition pattern TP, and the first side surfaces of the second active patterns AP2 may be coplanar with one another. A second surface of the transition pattern TP may extend diagonally with respect to second side surfaces of the first active patterns AP1 and second side surfaces of the second active patterns AP2 and may connect the second side surfaces of the first active patterns AP1 and the second side surfaces of the second active patterns AP2.

The first active patterns AP1, the second active patterns AP2, and the transition pattern TP may be arranged at the same level. For example, the transition pattern TP may be arranged at the same height as first, second, and third bridge patterns 111, 112, and 113 and fourth, fifth, and sixth bridge patterns 211, 212, and 213, relative to the upper surface of the substrate 100.

In some implementations, a separation structure DB may be formed on the third region III of the substrate and a field insulating film 105. The separation structure DB may intersect the transition pattern TP. For example, the separation structure DB may cut the transition pattern TP by extending in a second direction Y1. In some implementations, the bottom surface of the separation structure DB may be positioned at the same height as or lower than the upper surface of the substrate 100 (or the bottom surfaces of first and second fin patterns 110 and 210).

The separation structure DB may include an insulating material, for example, at least one of silicon oxide, silicon nitride, silicon oxynitride, and a combination thereof, but the present disclosure is not limited thereto. The separation structure DB may physically and electrically separate the first active patterns AP1 and the second active patterns AP2.

In some implementations, a sixth width WG3 of the separation structure DB may be the same as a third width WG1 of first gate structures GS1 and a fourth width WG2 of second gate structures GS2.

In some implementations, third gate spacers 340, third gate capping patterns 350, third inner spacers 345a, fourth inner spacers 345b, and third liner films 318 may be formed on the side surfaces of the separation structure DB.

The third gate spacers 340 may extend along the side surfaces of the separation structure DB. In some implementations, the third gate spacers 340 may be formed at the same level as first gate spacers 140 and second gate spacers 240. The third gate capping patterns 350 may extend along the upper surfaces of the third gate spacers 340. In some implementations, the third gate capping patterns 350 may be formed at the same level as first and second gate capping patterns 150 and 250.

The third inner spacers 345a may be formed on one side surface of the separation structure DB within the transition pattern TP. For example, the third inner spacers 345a may be interposed between the first epitaxial patterns 160 and the separation structure DB. In some implementations, the third inner spacers 345a may be formed at the same level as first inner spacers 145 and second inner spacers 245.

The fourth inner spacers 345b may be formed on the other side surface of the separation structure DB within the transition pattern TP. For example, the fourth inner spacers 345b may be interposed between the second epitaxial patterns 260 and the separation structure DB. In some implementations, the fourth inner spacers 345b may be formed at the same level as the first inner spacers 145 and the second inner spacers 245.

Third liner films 318 may be formed on the transition pattern TP, the third inner spacers 345a, and the fourth inner spacers 345b. The third liner films 318 may be interposed between the transition pattern TP and the third gate spacers 340, between the third inner spacers 345a and the third gate spacers 340, and between the fourth inner spacers 345b and the third gate spacers 340. In some implementations, the third liner films 318 may be formed at the same level as first and second liner films 118 and 218.

In some implementations, a first thickness TH1 of the first inner spacers 145 may be greater than a second thickness TH2 of the second inner spacers 245, and a third thickness TH3 of the third inner spacers 345a may be greater than a fourth thickness TH4 of the fourth inner spacers 345b. This is due to the fifth width WA3 of the transition pattern TP being less at the location where the third inner spacers 345a are formed than at the location where the fourth inner spacers 345b are formed.

FIG. 15 illustrates that the third thickness TH3 of the third inner spacers 345a is the same as the first thickness TH1 of the first inner spacers 145, but the present disclosure is not limited thereto. As the fifth width WA3 of the transition pattern TP is greater than the first width WA1 of the first active patterns AP1, at the location where the third inner spacers 345a are formed, the third thickness TH3 of the third inner spacers 345a may be less than the first thickness TH1 of the first inner spacers 145. Also, FIG. 15 illustrates that the fourth thickness TH4 of the fourth inner spacers 345b is the same as the second thickness TH2 of the second inner spacers 245, but the present disclosure is not limited thereto. As the fifth width WA3 of the transition pattern TP is greater than the second width WA2 of the second active patterns AP2, at the location where the fourth inner spacers 345b are formed, the fourth thickness TH4 of the fourth inner spacers 345b may be greater than the second thickness TH2 of the second inner spacers 245.

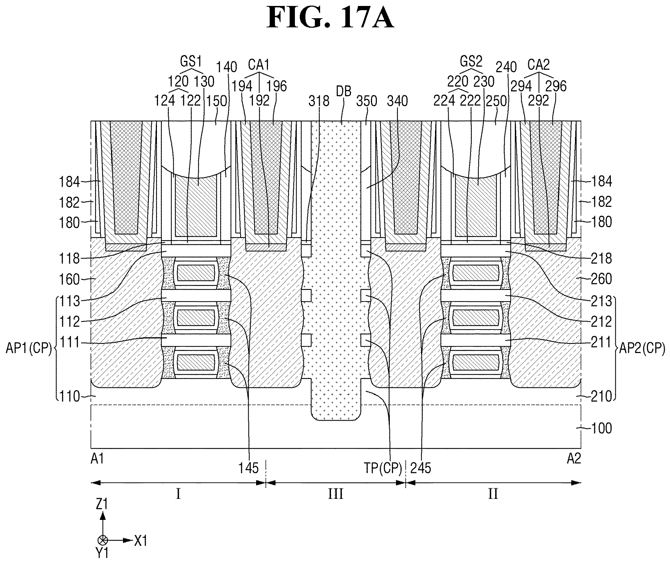

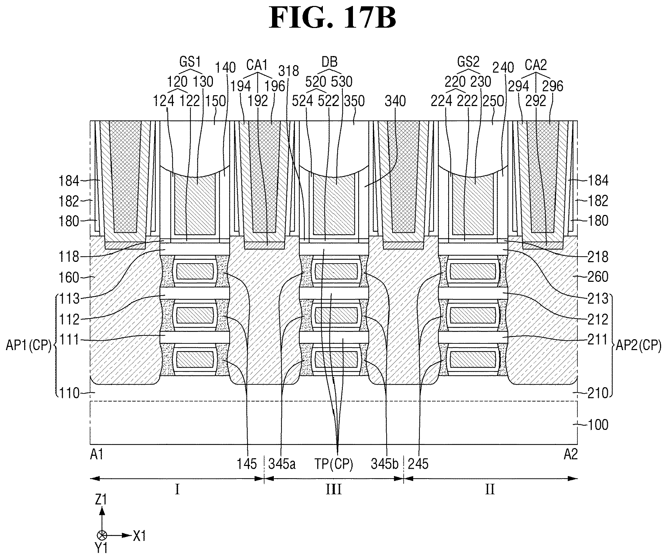

FIGS. 17A and 17B are example cross-sectional views of semiconductor devices. For convenience, redundant or repetitive portions that overlap with the content described earlier with reference to FIGS. 1 through 16 will be briefly mentioned or omitted.

Referring to FIG. 17A, a separation structure DB may be partially in contact with first and second epitaxial patterns 160 and 260.

For example, the third inner spacers 345a and the fourth inner spacers 345b of FIG. 16 may be removed, and portions of the separation structure DB may fill the regions where the third inner spacers 345a and the fourth inner spacers 345b have been removed. That is, the separation structure DB may include projections that protrude toward the first and second epitaxial patterns 160 and 260 within a transition pattern TP.

Referring to FIG. 17B, a separation structure DB may include a third gate dielectric film 520 and a third gate electrode 530.

The third gate dielectric film 520 may be stacked on a transition pattern TP. The third gate dielectric film 520 may surround the transition pattern TP. The third gate dielectric film 520 may include at least one of, for example, silicon oxide, silicon oxynitride, silicon nitride, or a high-k material with a greater dielectric constant than silicon oxide.

In some implementations, the third gate dielectric film 520 may include a third interfacial film 522 and a third high-k film 524, which are sequentially stacked on the transition pattern TP.

The third gate electrode 530 may be formed on a substrate 100. The third gate electrode 530 may be stacked on the third gate dielectric film 520. That is, the third gate electrode 530 may be interposed between the transition pattern TP and the third gate electrode 530. The third gate electrode 530 may be formed by, for example, a replacement process, but the present disclosure is not limited thereto. The third gate electrode 530 is illustrated as being a single film, but the present disclosure is not limited thereto. Alternatively, the third gate electrode 530 may be formed as a stack of multiple conductive layers.

In some implementations, the separation structure DB may be formed at the same level as first and second gate structures GS1 and GS2.

In some implementations, no voltage may be applied to the separation structure DB. That is, the separation structure DB may not be provided the gate of a FET, which is formed on a third region III. The separation structure DB may electrically separate first and second active patterns AP1 and AP2.

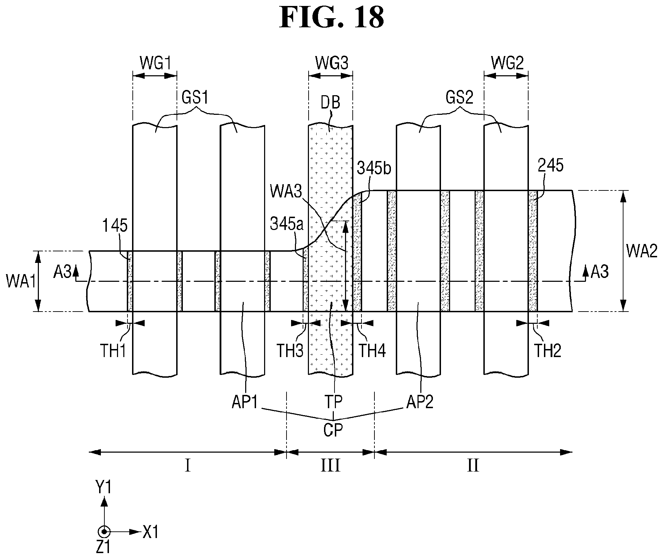

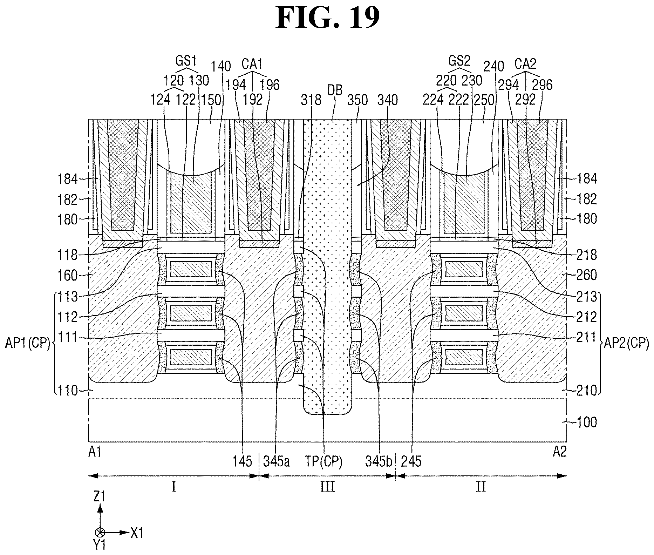

FIG. 18 is a layout view of another example of a semiconductor device. FIG. 19 is an example cross-sectional view taken along line A3-A3 of FIG. 18. For convenience, redundant or repetitive portions that overlap with the content described earlier with reference to FIGS. 1 through 17B will be briefly mentioned or omitted.

Referring to FIGS. 18 and 19, a first thickness TH1 of first inner spacers 145 may be less than a second thickness TH2 of second inner spacers 245, and a third thickness TH3 of third inner spacers 345a may be less than a fourth thickness TH4 of fourth inner spacers 345b.

This is due to a fifth width WA3 of a transition pattern TP being less at the location where the third inner spacers 345a are formed than at the location where the fourth inner spacers 345b are formed.

FIG. 18 illustrates that the third thickness TH3 of the third inner spacers 345a is the same as the first thickness TH1 of the first inner spacers 145, but the present disclosure is not limited thereto. Alternatively, as the fifth width WA3 of the transition pattern TP is less than the first width WA1 of the first active pattern AP1 at the location where the third inner spacers 345a are formed, the third thickness TH3 of the third inner spacers 345a may be greater than the first thickness TH1 of the first inner spacers 145. Also, FIG. 18 illustrates that the fourth thickness TH4 of the fourth inner spacers 345b is the same as the second thickness TH2 of the second inner spacers 245, but the present disclosure is not limited thereto. Alternatively, as the fifth width WA3 of the transition pattern TP is less than the second width WA2 of the second active pattern AP2 at the location where the fourth inner spacers 345b are formed, the fourth thickness TH4 of the fourth inner spacers 345b may be greater than the second thickness TH2 of the second inner spacers 245.

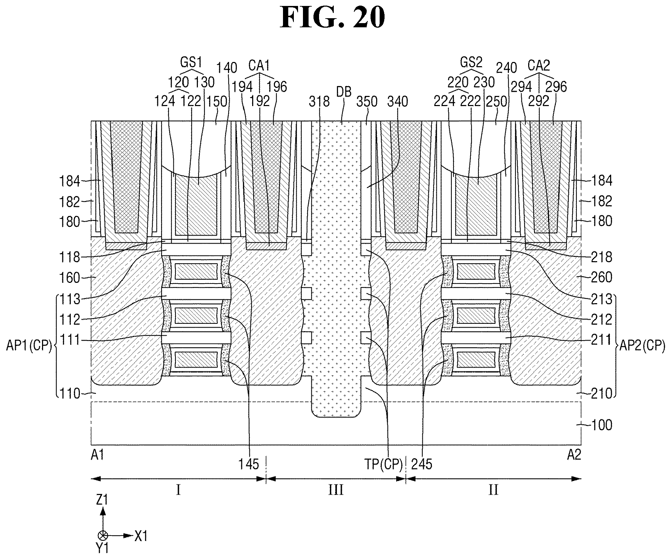

FIG. 20 is a cross-sectional view of another example of a semiconductor device. For convenience, redundant or repetitive portions that overlap with the content described earlier with reference to FIGS. 1 through 19 will be briefly mentioned or omitted.

Referring to FIG. 20, a separation structure DB may be partially in contact with first and second epitaxial patterns 160 and 260. The separation structure DB is similar to its counterpart of FIG. 17A, and thus, a detailed description thereof will be omitted.

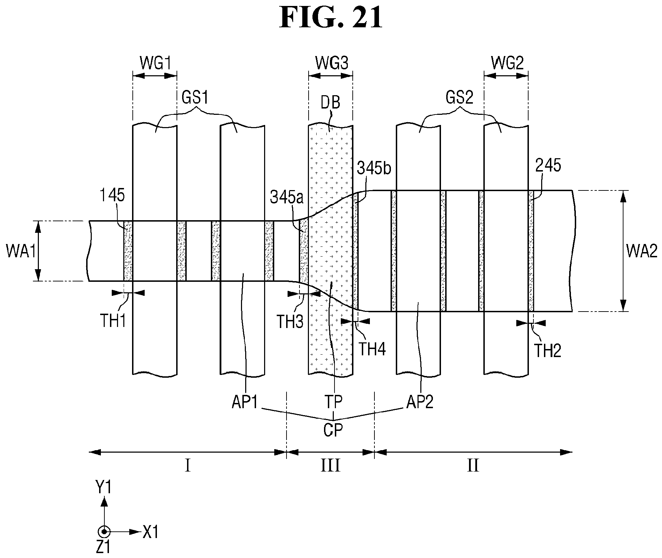

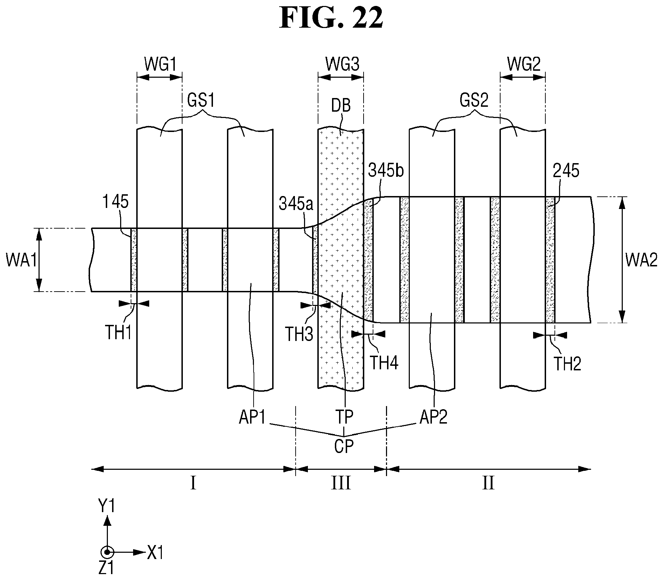

FIGS. 21 and 22 are example layout views of semiconductor devices. For convenience, redundant or repetitive portions that overlap with the content described earlier with reference to FIGS. 1 through 20 will be briefly mentioned or omitted.

Referring to FIGS. 21 and 22, both side surfaces of a transition pattern TP may not be aligned with both sides of each first active pattern AP1 and both sides of each second active pattern AP2.

For example, a first side surface of the transition pattern TP may connect first side surfaces of each first active pattern AP1 and each second active pattern AP2 by extending diagonally with respect to the first side surfaces of each first active pattern AP1 and each second active pattern AP2. Also, a second side surface of the transition pattern TP may connect second side surfaces of each first active pattern AP1 and each second active pattern AP2 by extending diagonally with respect to the second side surfaces of each first active pattern AP1 and each second active pattern AP2.

The semiconductor device of FIG. 21 is similar to its counterpart of FIG. 15 except for the shape of a channel structure CP, and the semiconductor device of FIG. 22 is almost similar to its counterpart of FIG. 18. Thus, detailed descriptions of the semiconductor devices of FIGS. 21 and 22 will be omitted.

Methods of fabricating a semiconductor device according to some implementations of the present disclosure will hereinafter be described with reference to FIGS. 1 through 38.

FIGS. 23 through 31 are layout views or cross-sectional views illustrating intermediate steps of an example of a method of fabricating a semiconductor device. For convenience, redundant or repetitive portions that overlap with the content described earlier with reference to FIGS. 1 through 22 will be briefly mentioned or omitted.

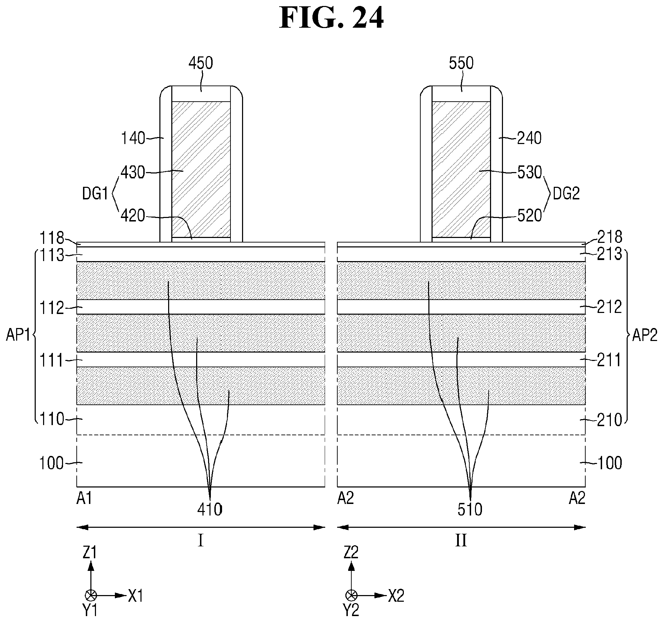

Referring to FIGS. 23 and 24, a first active pattern AP1, first sacrificial patterns 410, a first dummy gate structure DG1, and first gate spacers 140 are formed on a first region I of a substrate 100, and a second active pattern AP2, second sacrificial patterns 510, a second dummy gate structure DG2, and second gate spacers 240 are formed on a second region II of the substrate 100.

For example, first material films and second material films may be alternately formed on the first and second regions I and II of the substrate 100. Thereafter, a patterning process for patterning the first material films and the second material films may be performed. The patterned first material films on the first region I may form first sacrificial patterns 410, and the patterned second material films on the first region I may form first, second, and third bridge patterns 111, 112, and 113. The patterned first material films on the second region II may form second sacrificial patterns 510, and the patterned second material films on the second region II may form fourth, fifth, and sixth bridge patterns 211, 212, and 213.

The first sacrificial patterns 410 may have an etching selectivity with respect to the first, second, and third bridge patterns 111, 112, and 113, and the second sacrificial patterns 510 may have an etching selectivity with respect to the fourth, fifth, and sixth bridge patterns 211, 212, and 213. For example, the first, second, and third bridge patterns 111, 112, and 113 and the fourth, fifth, and sixth bridge patterns 211, 212, and 213 may include Si, and the first sacrificial patterns 410 and the second sacrificial patterns 510 may include SiGe.

In some implementations, during the patterning of the first material films and the second material films, the substrate 100 may be partially etched, and as a result, first and second fin patterns 110 and 210 may be formed.

In some implementations, a first liner film 118 may be formed on the first active pattern AP1 and the first sacrificial patterns 410, and a second liner film 218 may be formed on the second active pattern AP2 and the second sacrificial patterns 510.

Thereafter, a field insulating film 105 may be formed on the substrate. The field insulating film 105 may cover at least parts of the side surfaces of the first fin pattern 110 and at least parts of the side surfaces of the second fin pattern 210.

Thereafter, a first dummy gate structure DG1 may be formed on the first active pattern AP1 and the first sacrificial patterns 410, and a second dummy gate structure DG2 may be formed on the second active pattern AP2 and the second sacrificial patterns 510.

The first and second dummy gate structures DG1 and DG2 may extend along the upper surfaces of the substrate 100 and the field insulating film 105. The first dummy gate structure DG1 may intersect the first active pattern AP1. For example, the first dummy gate structure DG1 may extend in a second direction Y1. The second dummy gate structure DG2 may intersect the second active pattern AP2. For example, the second dummy gate structure DG2 may extend in a fifth direction Y2.

In some implementations, the first dummy gate structure DG1 may include a first dummy gate dielectric film 320 and a first dummy gate electrode 330, and the second dummy gate structure DG2 may include a second dummy gate dielectric film 420 and a second dummy gate electrode 430. For example, a dielectric film and an electrode film may be sequentially stacked on the substrate 100 and the field insulating film 105. Thereafter, a first mask pattern 450, which extends in the second direction Y1, may be formed on the electrode film on the first region I. Also, a second mask pattern 550, which extends in the fifth direction Y2, may be formed on the electrode film on the second region II. Thereafter, a patterning process for patterning the dielectric film and the electrode film using the first and second mask patterns 450 and 550 as etching masks may be performed. The patterned dielectric film on the first region I may form the first dummy gate dielectric film 320, and the patterned electrode film on the first region I may form the first dummy gate electrode 330. The patterned dielectric film on the second region II may form the second dummy gate dielectric film 420, and the patterned electrode film on the second region II may form the second dummy gate electrode 430.

The first dummy gate structure DG1 may have a different etching selectivity from the first, second, and third bridge patterns 111, 112, and 113 and the first sacrificial patterns 410, and the second dummy gate structure DG2 may have a different etching selectivity from the fourth, fifth, and sixth bridge patterns 211, 212, and 213 and the second sacrificial patterns 510. For example, the first and second dummy gate electrodes 330 and 430 may include polysilicon (poly-Si).

Thereafter, first gate spacers 140 and second gate spacers 240 may be formed. The first gate spacers 140 may be formed on the substrate 100 and the field insulating film 105. The first gate spacers 140 may extend along the side surfaces of the first dummy gate structure DG1. The second gate spacers 240 may be formed on the substrate 100 and the field insulating film 105. The second gate spacers 240 may extend along the side surfaces of the second dummy gate structure DG2.

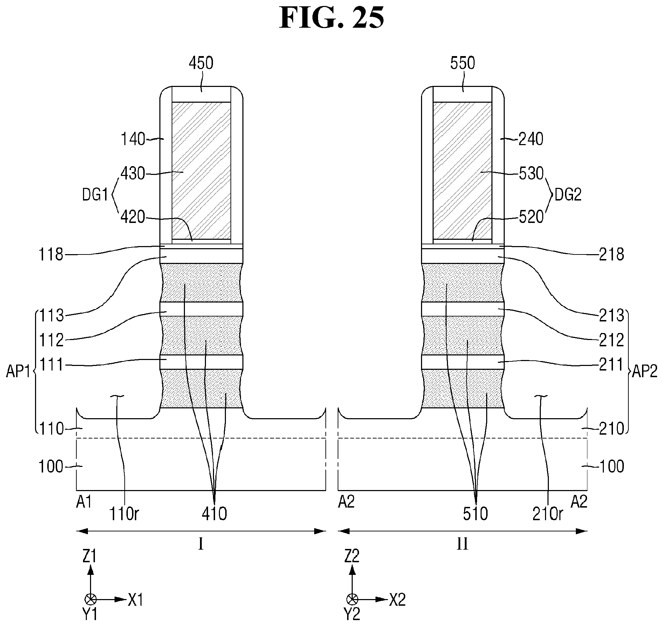

Referring to FIG. 25, a first recess process is performed on the first active pattern AP1, the first sacrificial patterns 410, the second active pattern AP2, and the second sacrificial patterns 510.

As a result of the first recess process, parts of the first, second, and third bridge patterns 111, 112, and 113 on the outside of the first dummy gate structure DG1 and parts of the first sacrificial patterns 410 may be removed, thereby forming first recesses 110r. In some implementations, upper portions of the first fin pattern 110 may be removed during the formation of the first recesses 1 10r.

As a result of the first recess process, parts of the fourth, fifth, and sixth bridge patterns 211, 212, and 213 on the outside of the second dummy gate structure DG2 and parts of the second sacrificial patterns 510 may be removed, thereby forming second recesses 210r. In some implementations, upper portions of the second fin pattern 210 may be removed during the formation of the second recesses 210r.

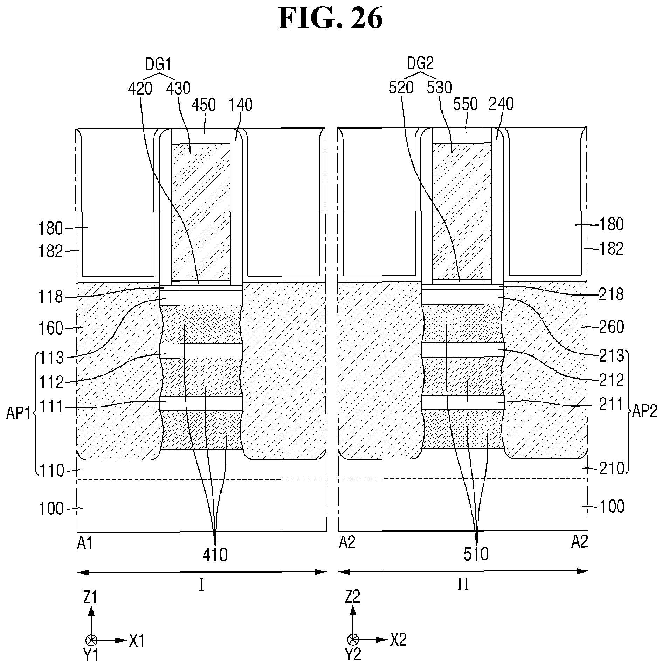

Referring to FIG. 26, first epitaxial patterns 160 and second epitaxial patterns 260 are formed.

The first epitaxial patterns 160 may at least partially fill the first recesses 110r of FIG. 25. The first epitaxial patterns 160 may be formed by an epitaxial growth method using the first active pattern AP1 as a seed layer. As a result, the first epitaxial patterns 160, which are connected to the first active pattern AP1, may be formed.

The second epitaxial patterns 260 may at least partially fill the second recesses 210r of FIG. 25. The second epitaxial patterns 260 may be formed by an epitaxial growth method using the second active pattern AP2 as a seed layer. As a result, the second epitaxial patterns 260, which are connected to the second active pattern AP2, may be formed.

In some implementations, the first epitaxial patterns 160 may be grown using the first active pattern AP1 and the first sacrificial patterns 410 as seed layers, and the second epitaxial patterns 260 may be grown using the second active pattern AP2 and the second sacrificial patterns 510 as seed layers. For example, the first, second, and third bridge patterns 111, 112, and 113 and the fourth, fifth, and sixth bridge patterns 211, 212, and 213 may include Si, and the first sacrificial patterns 410 and the second sacrificial patterns 510 may include SiGe. In this manner, a high-performance semiconductor device can be achieved by preventing defects in the first epitaxial patterns 160 and the second epitaxial patterns 260 (e.g., stacking defects).

After the formation of the first epitaxial patterns 160 and the second epitaxial patterns 260, an etch stopper film 182 and an interlayer insulating film 180 may be formed.

The etch stopper film 182 may cover the first epitaxial patterns 160 and the second epitaxial patterns 260. The interlayer insulating film 180 may be formed on the etch stopper film 182 and may fill the spaces on the outside of the first gate spacers 140 and the spaces on the outside of the second gate spacers 240.

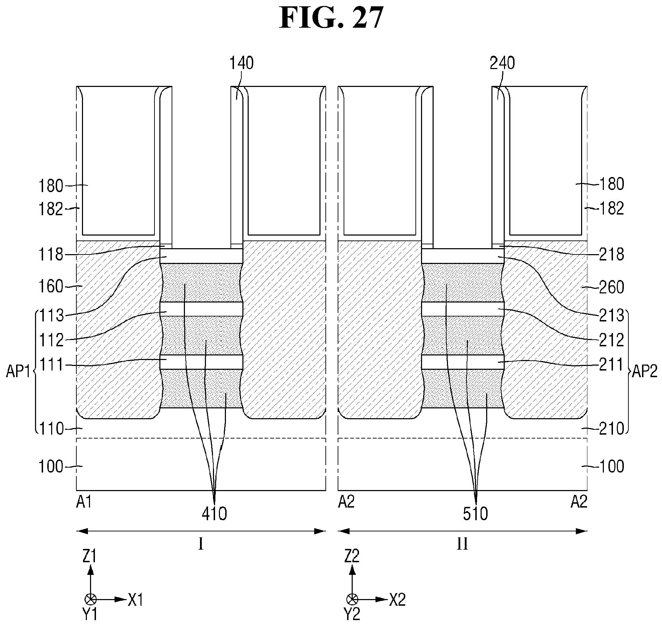

Referring to FIG. 27, the first and second dummy gate structures DG1 and DG2 are removed.

As mentioned earlier, as the first dummy gate structure DG1 has a different etching selectivity from the first, second, and third bridge patterns 111, 112, and 113 and the first sacrificial patterns 410 and the second dummy gate structure DG2 has a different etching selectivity from the fourth, fifth, and sixth bridge patterns 211, 212, and 213 and the second sacrificial patterns 510, the first and second dummy gate structures DG1 and DG2 can be selectively removed. As a result of the removal of the first dummy gate structure DG1, the first active pattern AP1 and the first sacrificial patterns 410 may be exposed on the inside of the first gate spacers 140. Also, as a result of the removal of the second dummy gate structure DG2, the second active pattern AP2 and the second sacrificial patterns 510 may be exposed on the inside of the second gate spacers 240.

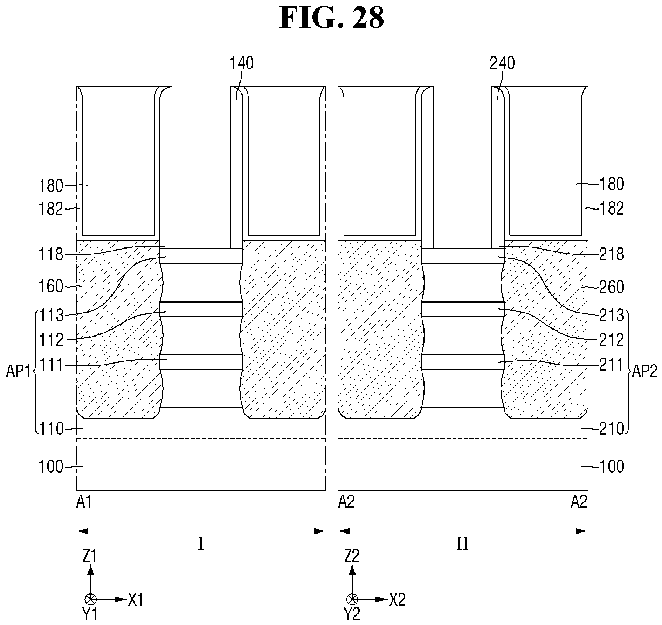

Referring to FIG. 28, the first sacrificial patterns 410 and the second sacrificial patterns 510 are removed.

As mentioned earlier, as the first dummy gate structure DG1 has a different etching selectivity from the first sacrificial patterns 410 and the second dummy gate structure DG2 has a different etching selectivity from the second sacrificial patterns 510, the first sacrificial patterns 410 and the second sacrificial patterns 510 can be selectively removed. As a result of the removal of the first sacrificial patterns 410 and the second sacrificial patterns 510, first, second, and third bridge patterns 111, 112, and 113 that are spaced apart from one another on the first region I of the substrate 100 may be formed, and fourth, fifth, and sixth bridge patterns 211, 212, and 213 that are spaced apart from one another on the second region II of the substrate 100 may be formed.

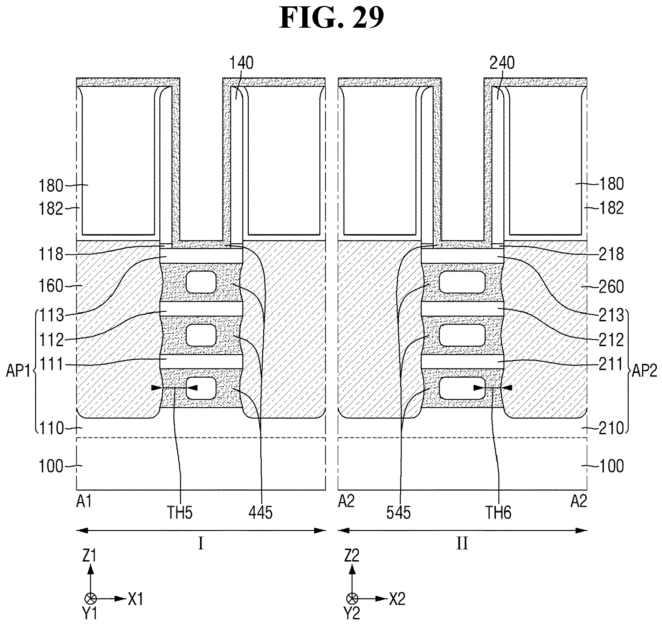

Referring to FIG. 29, first and second spacer films 445 and 545 are formed.

The first spacer film 445 may be stacked on the first active pattern AP1, and the second spacer film 545 may be stacked on the second active pattern AP2. In some implementations, the first spacer film 445 may not completely fill the spaces within the first active pattern AP1, and the second spacer film 545 may not completely fill the spaces within the second active pattern AP2.

The first and second spacer films 445 and 545 may include at least one of, for example, silicon nitride, silicon oxynitride, silicon oxycarbide, silicon boron nitride, silicon boron carbonitride, silicon oxycarbonitride, and a combination thereof, but the present disclosure is not limited thereto. For example, the first and second spacer films 445 and 545 may include silicon oxide films. The first and second spacer films 445 and 545 may be formed by, for example, a chemical vapor deposition (CVD) method or an atomic layer deposition (ALD) method, but the present disclosure is not limited thereto.

In some implementations, a fifth thickness TH5 of the first spacer film 445 on the side surfaces of the first epitaxial patterns 160 may be greater than a sixth thickness TH6 of the second spacer film 545 on the side surfaces of the second epitaxial patterns 260. This is due to a first width ("WA1" of FIG. 23) of the first active pattern AP1 being less than a second width (e.g., "WA2" of FIG. 23) of the second active pattern AP2. Specifically, as the space within the first active pattern AP1 is narrower than the space within the second active pattern AP2, the first spacer film 445 may experience folding.

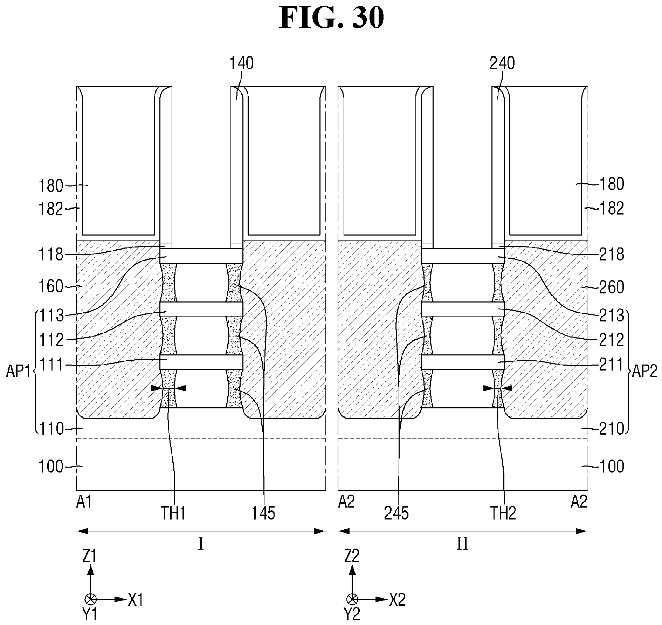

Referring to FIG. 30, first inner spacers 145 and second inner spacers 245 are formed.

For example, a second recess process may be performed on the first spacer films 445 and the second spacer films 545 of FIG. 29. During the second recess process, the first and second spacer films 445 and 545 may not be able to be completely removed from the side surfaces of the first epitaxial patterns 160 within the first active pattern AP1 and from the side surfaces of the second epitaxial patterns 160 within the second active pattern AP2. This is due to the spaces within the first and second active patterns AP1 and AP2 being narrower than the spaces on the outside of the first active pattern AP1 and on the outside of the second active pattern AP2. Consequently, the first inner spacers 145 may be formed in the first active pattern AP1, and the second inner spacers 245 may be formed in the second active pattern AP2.

As the first spacer film 445 is folded, a first thickness TH1 of the first inner spacers 145 may be greater than a second thickness TH2 of the second inner spacers 245 after the second recess process.

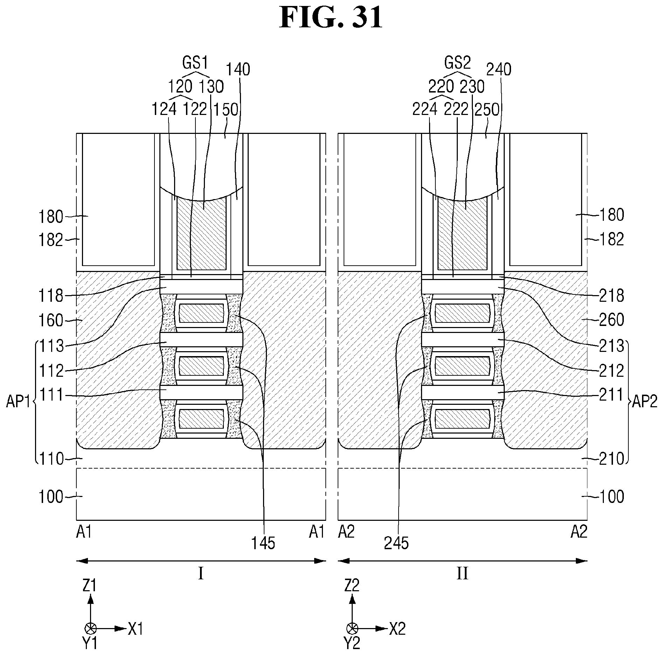

Referring to FIG. 31, first and second gate structures GS1 and GS2 are formed.

For example, a first gate dielectric film 120 and a first gate electrode 130 may be sequentially stacked on the first active pattern AP1, and a second gate dielectric film 220 and a second gate electrode 230 may be sequentially stacked on the second active pattern AP2. Thereafter, a first gate capping pattern 150 may be formed on the first gate electrode 130, and a second gate capping pattern 250 may be formed on the second gate electrode 230. In some implementations, the first and second gate capping patterns 150 and 250 may be formed after the performing an etch-back process on the first and second gate electrodes 130 and 230.

Thereafter, referring again to FIG. 2, first source/drain contacts CA1 and second source/drain contacts CA2 are formed. In this manner, the semiconductor device of FIGS. 1 through 5 can be obtained.

Research is being conducted on inner spacers positioned between gates (hereinafter, "the inner gates") and sources/drains in a semiconductor device with a multi-bridge channel to mitigate leakage current and parasitic capacitance within the multi-bridge channel. However, the growth of the sources/drains on the inner spacers presents challenges in applying stress and controlling dispersion through the sources/drains due to stacking defects and other factors, resulting in a decline in the performance of the semiconductor device.

However, as mentioned above, first inner spacers 145 and second inner spacers 245 can be formed after the formation of first epitaxial patterns 160 and second epitaxial patterns 260, which are provided as sources/drains. In other words, the first epitaxial patterns 160 and the second epitaxial patterns 260 can be formed before the formation of the first inner spacers 145 and the second inner spacers 245, thereby preventing problems caused by, for example, stacking defects. As a result, a semiconductor device with improved performance can be provided.

FIGS. 32 through 34 are cross-sectional views illustrating intermediate steps of an example of a method of fabricating a semiconductor device. For convenience, redundant or repetitive portions that overlap with the content described earlier with reference to FIGS. 1 through 31 will be briefly mentioned or omitted.

Referring to FIGS. 23 and 32, first sacrificial patterns 410 and second sacrificial patterns 510 may be further formed on uppermost bridge patterns (e.g., third and sixth bridge patterns 113 and 213).

For example, the first sacrificial patterns 410 may be formed not only between a first bridge pattern 111, a second bridge pattern 112, and the third bridge pattern 113 and between a first fin pattern 110 and the first bridge pattern 111, but also on the upper surface of the third bridge pattern 113. The first sacrificial patterns 410 that are positioned on the upper surface of the third bridge pattern 113 will hereinafter be referred to as uppermost first sacrificial patterns 410. The first sacrificial patterns 410 may be interposed between the third bridge pattern 113 and first gate spacers 140. In some implementations, a first liner film 118 may be interposed between the uppermost first sacrificial patterns 410 and the first gate spacers 140.

For example, the second sacrificial patterns 510 may be formed not only between a fourth bridge pattern 211, a fifth bridge pattern 212, and the sixth bridge pattern 213 and between a second fin pattern 210 and the fourth bridge pattern 211, but also on the upper surface of the sixth bridge pattern 213. The second sacrificial patterns 510 that are positioned on the upper surface of the sixth bridge pattern 213 will hereinafter be referred to as uppermost second sacrificial patterns 510. The second sacrificial patterns 510 may be interposed between the sixth bridge pattern 213 and second gate spacers 240. In some implementations, a second liner film 218 may be interposed between the uppermost second sacrificial patterns 510 and the second gate spacers 240.

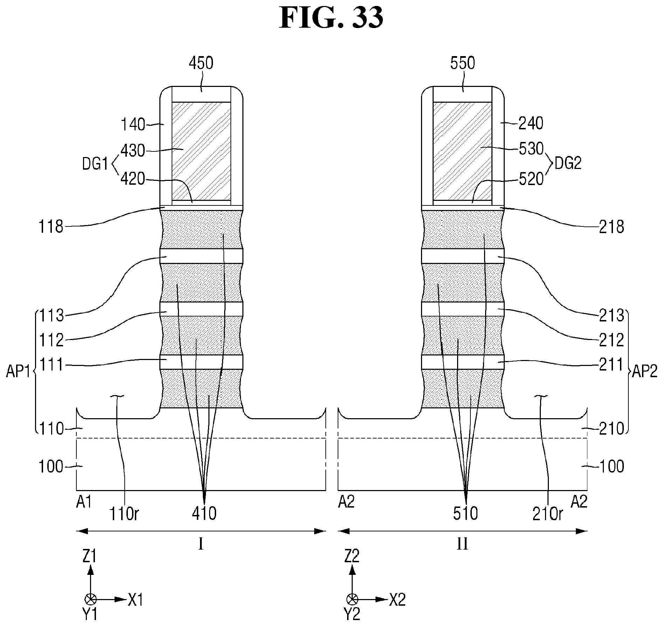

Referring to FIG. 33, a first recess process is performed on a fist active pattern AP1, the first sacrificial patterns 410, a second active pattern AP2, and the second sacrificial patterns 510. The first recess process is as already described above with reference to FIG. 25, and thus, a detailed description thereof will be omitted.

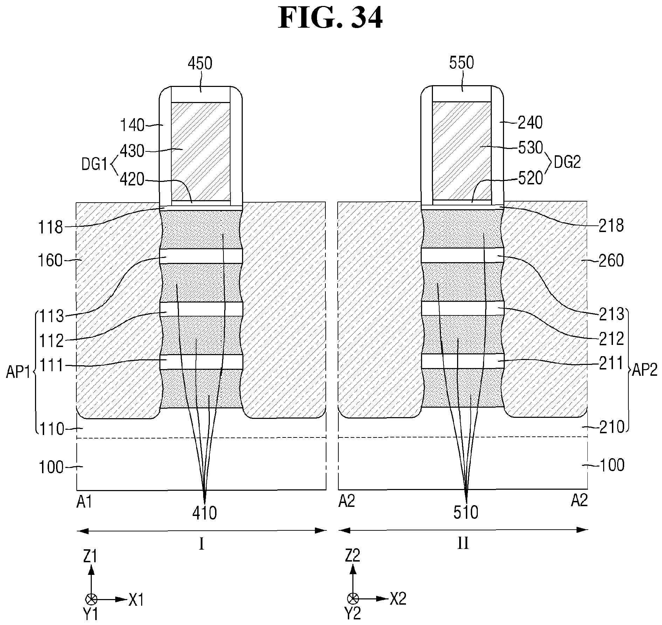

Referring to FIG. 34, first epitaxial patterns 160 and second epitaxial patterns 260 are formed. The formation of the first epitaxial patterns 160 and the second epitaxial patterns 260 is as already described above with reference to FIG. 26, and thus, a detailed description thereof will be omitted.

As the first epitaxial patterns 160 can be grown using the first active pattern AP1 and the first sacrificial patterns 410 as seed layers, the uppermost surfaces of the first epitaxial patterns 160 may be formed to be at the same height as or higher than the upper surfaces of the uppermost first sacrificial patterns 410. Also, as the second epitaxial patterns 260 can be grown using the second active pattern AP2 and the second sacrificial patterns 510 as seed layers, the uppermost surfaces of the second epitaxial patterns 260 may be formed to be at the same height as or higher than the upper surfaces of the uppermost second sacrificial patterns 510.

Thereafter, the steps depicted in FIGS. 2 and 26 through 31 may be performed. In this manner, the semiconductor device of FIG. 9 can be obtained.

FIGS. 35 and 36 are cross-sectional views illustrating intermediate steps of another example of a method of fabricating a semiconductor device. For convenience, redundant or repetitive portions that overlap with the content described earlier with reference to FIGS. 1 through 34 will be briefly mentioned or omitted. Specifically, FIG. 35 illustrates an intermediate step to be performed after that depicted in FIG. 25.

Referring to FIG. 35, a third recess process is performed on first sacrificial patterns 410 and second sacrificial patterns 510.

As a result of the third recess process, parts of exposed first sacrificial patterns 410 may be removed, thereby forming third recesses 410r, and parts of exposed second sacrificial patterns 510 may be removed, thereby forming fourth recesses 510r.

In some implementations, a first depth DT1 of the third recesses 410r may be less than a second depth DT2 of the fourth recesses 510r. This is due to a first width ("WA1" of FIG. 23) of the first active pattern AP1 being less than a second width ("WA2" of FIG. 23) of the second active pattern AP2. Specifically, as the space within the first active pattern AP1 is narrower than the space within the second active pattern AP2, a loading phenomenon may occur where the etching rate of the third recess process for the first sacrificial patterns 410 is reduced.

Referring to FIG. 36, first inner spacers 145 and second inner spacers 245 are formed.

For example, an insulating film may be formed on the outer side surfaces of the first gate spacers 140 and the outer side surfaces of the second gate spacers 240, and a fourth recess process may be performed on the insulating film. As a result of the fourth recess process, the first inner spacers 145, which fill the third recesses 410r of FIG. 35, and the second inner spacers 245, which fill the fourth recesses 510r of FIG. 35, may be formed.

Due to the loading phenomenon, a first thickness TH1 of the first inner spacers 145 may be less than a second thickness TH2 of the second inner spacers 245 after the fourth recess process.

Thereafter, the steps depicted in FIGS. 2 and 26 through 31 may be performed. In this manner, the semiconductor device of FIGS. 10 and 11 can be obtained.

FIGS. 37 and 38 are cross-sectional views illustrating intermediate steps of another example of a method of fabricating a semiconductor device. For convenience, redundant or repetitive portions that overlap with the content described earlier with reference to FIGS. 1 through 36 will be briefly mentioned or omitted. Specifically, FIG. 37 illustrates an intermediate step to be performed after that depicted in FIG. 33.

Referring to FIG. 37, a third recess process is performed on first sacrificial patterns 410 and second sacrificial patterns 510. The third recess process is as already described above with reference to FIG. 35, and thus, a detailed description thereof will be omitted.

Referring to FIG. 38, first inner spacers 145 and second inner spacers 245 are formed. The formation of the first inner spacers 145 and the second inner spacers 245 is as already described above with reference to FIG. 36, and thus, a detailed description thereof will be omitted.

Thereafter, the steps depicted in FIGS. 2 and 26 through 31 may be performed. In this manner, the semiconductor device of FIG. 14 can be obtained.

As mentioned earlier, first inner spacers 145 and second inner spacers 245 with varying thicknesses depending on the region can be provided. Accordingly, inner spacers with a required thickness can be provided, and as a result, the performance of a semiconductor device can be enhanced.

While this specification contains many specific implementation details, these should not be construed as limitations on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations and even initially be claimed as such, one or more features from a claimed combination can in some cases be excised from the combination, and the claimed combination may be directed to a sub-combination or variation of a sub-combination.

In concluding the detailed description, those skilled in the art will appreciate that many variations and modifications may be made to the preferred implementations without substantially departing from the principles of the present concept. Therefore, the disclosed preferred implementations of the disclosure are used in a generic and descriptive sense only and not for purposes of limitation.

## Claims

1. A semiconductor device comprising:
a substrate including a first region and a second region;
a first bridge pattern on the first region, the first bridge pattern extending in a first direction and spaced apart from the substrate, and the first bridge pattern having a first width;
a first gate structure extending in a second direction, wherein the second direction intersects the first direction, and the first bridge pattern extends through the first gate structure;
first epitaxial patterns connected to the first bridge pattern on side surfaces of the first gate structure;
first inner spacers interposed between the substrate and the first bridge pattern and between the first gate structure and the first epitaxial patterns;
a second bridge pattern extending in the first direction on the second region, the second bridge pattern spaced apart from the substrate, the second bridge pattern having a second width, and the second width being greater than the first width;
a second gate structure extending in the second direction, wherein the second bridge pattern extends through the second gate structure;
second epitaxial patterns connected to the second bridge pattern on side surfaces of the second gate structure; and
second inner spacers interposed between the substrate and the second bridge pattern and between the second gate structure and the second epitaxial patterns.

2. The semiconductor device of claim 1, wherein a first thickness of the first inner spacers in the first direction is greater than a second thickness of the second inner spacers in the first direction.

3. The semiconductor device of claim 2, wherein
inner side surfaces of the first inner spacers that are opposite to the first gate structure include concave surfaces, and
inner side surfaces of the second inner spacers that are opposite to the second gate structure include concave surfaces.

4. The semiconductor device of claim 1, wherein a first thickness of the first inner spacers in the first direction is less than a second thickness of the second inner spacers in the first direction.

5. The semiconductor device of claim 4, wherein
inner side surfaces of the first inner spacers that are opposite to the first gate structure include convex surfaces, and
inner side surfaces of the second inner spacers that are opposite to the second gate structure include convex surfaces.

6. The semiconductor device of any preceding claim, wherein
outer side surfaces of the first inner spacers that are opposite to the first epitaxial patterns include concave surfaces, and
outer side surfaces of the second inner spacers that are opposite to the second epitaxial patterns include concave surfaces.

7. The semiconductor device of any preceding claim, wherein
the first epitaxial patterns are in contact with the first inner spacers, and
the second epitaxial patterns are in contact with the second inner spacers.

8. The semiconductor device of any preceding claim, further comprising:
a transition pattern between the first bridge pattern and the second bridge pattern, the transition pattern connecting the first bridge pattern to the second bridge pattern,
wherein a third width of the transition pattern increases in a direction from the first bridge pattern to the second bridge pattern.

9. The semiconductor device of any preceding claim, further comprising:
a third bridge pattern, wherein the third bridge pattern is further away from the substrate than the first bridge pattern on the first region, and the third bridge pattern extends through the first gate structure in the first direction; and
a fourth bridge pattern, wherein the fourth bridge pattern is further away from the substrate than the second bridge pattern on the second region, and the fourth bridge pattern extends through the second gate structure in the first direction.

10. The semiconductor device of claim 9, wherein
the first inner spacers are interposed between the first bridge pattern and third bridge pattern, and
the second inner spacers are interposed between the second bridge pattern and fourth bridge pattern.

11. The semiconductor device of any preceding claim, wherein
the first width is 5 nm to 20 nm, and
the second width is 20 nm to 100 nm.

12. A semiconductor device comprising:
a substrate including a first region and a second region;
a first bridge pattern and a second bridge pattern that are sequentially stacked on the first region, the first bridge pattern and the second bridge pattern extending in a first direction and spaced apart from the substrate;
a first gate structure extending in a second direction, wherein the second direction intersects the first direction, and the first bridge pattern and the second bridge pattern extend through the first gate structure;
first inner spacers on side surfaces of the first gate structure and between the first bridge pattern and the second bridge pattern;
first epitaxial patterns connected to the first bridge pattern and the second bridge pattern on outer side surfaces of the first inner spacers;
a third bridge pattern and a fourth bridge pattern that are sequentially stacked on the second region, the third and fourth bridge patterns extending in the first direction;
a second gate structure extending in the second direction, wherein the third bridge pattern and the fourth bridge pattern extend through the second gate structure;
second inner spacers disposed on side surfaces of the second gate structure and between the third bridge pattern and the fourth bridge pattern; and
second epitaxial patterns connected to the third bridge pattern and the fourth bridge pattern on outer side surfaces of the second inner spacers,
wherein a first width of the first bridge pattern and the second bridge pattern in the second direction is less than a second width of the third bridge pattern and the fourth bridge pattern in the second direction, and
wherein a first thickness of the first inner spacers in the first direction is greater than a second thickness of the second inner spacers in the first direction.

13. The semiconductor device of claim 12, wherein the first thickness of the first inner spacers decreases to a point and, from the point, increases along a direction away from the first bridge pattern.

14. The semiconductor device of claim 12 or 13, wherein inner side surfaces of the first inner spacers that are opposite to the first gate structure include concave surfaces.

15. The semiconductor device of any of claims 12 to 14, wherein outer side surfaces of the first inner spacers that are opposite to the first epitaxial patterns include concave surfaces.
